# EUROPEAN PATENT APPLICATION

(11) **EP 4 804 775 A1**
(43) Date of publication of application: **09.09.2026**
(21) Application number: 26158782.8
(22) Date of filing: 16.02.2026
(51) Int. Cl.: H10K 59/35, H10K 59/122

(54) **DISPLAY PANEL, DISPLAY DEVICE AND ELECTRONIC DEVICE**

(30) Priority: 06.03.2025 KR 20250028896; 11.04.2025 KR 20250047630
(71) Applicant: Samsung Display Co., Ltd., Yongin-si, Gyeonggi-do 17113 (KR)
(72) Inventor: SHIN, Kyoung Ju, 17113 Giheung-gu, Yongin-si, Gyeonggi-do (KR); HAN, Yun Seok, 17113 Giheung-gu, Yongin-si, Gyeonggi-do (KR)
(74) Representative: Dr. Weitzel & Partner

(57) **Abstract**

A display panel or display device with a display panel includes: a substrate; a pixel defining layer on the substrate; and a first light emitting element in a first light emitting area, a second light emitting element in a second light emitting area, and a third light emitting element in a third light emitting area that are adjacent to each other. During a light emitting period to express a white color, a first electrode of the third light emitting element is to be applied with a third voltage greater than a first voltage applied to a first electrode of the first light emitting element and a second voltage applied to a first electrode of the second light emitting element, and a spacing between the second light emitting area and the third light emitting area is greater than a spacing between the first light emitting area and the second light emitting area.

## Description

The present invention relates to a display panel, a display device and an electronic device capable of displaying an image.

As information society develops, the demand for a display device and an electronic device capable of displaying an image is increasing in various forms. Accordingly, various kinds of display devices and electronic devices including pixels are being developed. The display device may be provided alone, or may be included in an electronic device and used as a display screen of the electronic device.

The display device and the electronic device may be used in a variety of environments. In addition, the display device and the electronic device may be used at a temperature higher than a room temperature due to heat generation from processors and the like, and a thermal insulating effect caused by a window, a case, and the like. Therefore, it may be desirable for the display device and the electronic device to have a high temperature stability to maintain or substantially maintain a uniform luminance and color, even under temperature changes.

The above information is for enhancement of understanding of the background of the present invention, and therefore, it may contain information that does not constitute prior art.

Embodiments of the present invention may be directed to a display panel, a display device and an electronic device capable of reducing a leakage current between sub-pixels, and having an improved temperature stability.

The invention is defined by claim 1. The dependent claims and the description provide preferred embodiments.

However, the present invention is not limited to the above aspects and features. The above and additional aspects and features will be set forth, in part, in the description that follows, and in part, may be apparent from the description, or may be learned by practicing one or more of the presented embodiments of the present invention.

According to the present invention, a display panel includes: a substrate; a pixel defining layer on the substrate, and defining a plurality of light emitting areas including a first light emitting area, a second light emitting area, and a third light emitting area that are adjacent to each other; and a plurality of light emitting elements on the substrate, and including a first light emitting element in the first light emitting area, a second light emitting element in the second light emitting area, and a third light emitting element in the third light emitting area. During a light emitting period in which the first light emitting element, the second light emitting element, and the third light emitting element are configured to emit light to express a white color, especially a standard white color, a first electrode of the third light emitting element is configured to be applied with a third voltage greater than a first voltage applied to a first electrode of the first light emitting element and a second voltage applied to a first electrode of the second light emitting element. A spacing between the second light emitting area and the third light emitting area is greater than a spacing between the first light emitting area and the second light emitting area.

In an embodiment, a difference between the third voltage and the second voltage may be greater than a difference between the first voltage and the second voltage.

In an embodiment, the first light emitting element may be a red light emitting element configured to emit red light, the second light emitting element may be a green light emitting element configured to emit green light, and the third light emitting element may be a blue light emitting element configured to emit blue light.

In an embodiment, each of the first light emitting element, the second light emitting element, and the third light emitting element may include an organic light emitting layer, the organic light emitting layer being individually located in the first light emitting area, the second light emitting area, and the third light emitting area.

In an embodiment, during the light emitting period, the third light emitting element may be configured to emit light having a lower luminance than those of the first light emitting element and the second light emitting element.

In an embodiment, during the light emitting period, a first driving current, a second driving current, and a third driving current may flow through the first light emitting element, the second light emitting element, and the third light emitting element, respectively, and the third driving current may be greater than the first driving current and the second driving current.

In an embodiment, the second light emitting area may have a shape that extends in a direction toward the first light emitting area.

In an embodiment, the display panel may further include a separation structure between the second light emitting area and the third light emitting area.

In an embodiment, the second light emitting area may have a shape extending in one direction, and may have a long side facing the third light emitting area. The separation structure may extend in the one direction in which the second light emitting area extends, and may be parallel to the long side of the second light emitting area.

In an embodiment, the separation structure may be located on respective sides of the second light emitting area.

In an embodiment, the display panel may further include a backplane layer between a light emitting element layer and the substrate, the light emitting element layer including the light emitting elements, and the backplane layer may include transistors electrically connected to the plurality of light emitting elements, and an insulating layer on the transistors.

In an embodiment, the display panel may further include connection holes electrically connecting the plurality of light emitting elements to the transistors by penetrating through the insulating layer. The connection holes may not be located between the first light emitting area and the second light emitting area in a non-light emitting area around the plurality of light emitting areas, and may be located in another portion of the non-light emitting area.

In an embodiment, the plurality of light emitting areas may include a plurality of first light emitting areas including the first light emitting area, a plurality of second light emitting areas including the second light emitting area, and a plurality of third light emitting areas including the third light emitting area. Each of the connection holes may be located between corresponding first and third light emitting areas that are adjacent to each other, or between corresponding second and third light emitting areas that adjacent to each other, among the plurality of light emitting areas.

According to one or more embodiments of the present invention, an electronic device includes: a display module including a display panel; and a processor configured to transmit an image data signal to the display module. The display module may form part of a display device. The display panel includes: a substrate; a pixel defining layer on the substrate, and defining a plurality of light emitting areas including a first light emitting area, a second light emitting area, and a third light emitting area that are adjacent to each other; and a plurality of light emitting elements on the substrate, and including a first light emitting element in the first light emitting area, a second light emitting element in the second light emitting area, and a third light emitting element in the third light emitting area. During a light emitting period in which the first light emitting element, the second light emitting element, and the third light emitting element are configured to emit light to express a white color, especially a standard white color, a first electrode of the third light emitting element is configured to be applied with a third voltage greater than a first voltage applied to a first electrode of the first light emitting element and a second voltage applied to a first electrode of the second light emitting element. A spacing between the second light emitting area and the third light emitting area is greater than a spacing between the first light emitting area and the second light emitting area.

In an embodiment, a difference between the third voltage and the second voltage may be greater than a difference between the first voltage and the second voltage.

In an embodiment, the first light emitting element may be a red light emitting element configured to emit red light, the second light emitting element may be a green light emitting element configured to emit green light, and the third light emitting element may be a blue light emitting element configured to emit blue light.

In an embodiment, the second light emitting area may have a shape that extends in a direction toward the first light emitting area.

In an embodiment, the display panel may further include a separation structure between the second light emitting area and the third light emitting area.

In an embodiment, the display panel may further include a backplane layer between a light emitting element layer and the substrate, the light emitting element layer including the light emitting elements, and the backplane layer may include transistors electrically connected to the plurality of light emitting elements, and an insulating layer on the transistors.

In an embodiment, the display panel may further include connection holes electrically connecting the plurality of light emitting elements to the transistors by penetrating through the insulating layer. The connection holes may not be located between the first light emitting area and the second light emitting area in a non-light emitting area around the plurality of light emitting areas, and may be located in another portion of the non-light emitting area.

The invention may be also be defined as a method of driving a display panel, wherein the display panel includes: a substrate; a pixel defining layer on the substrate, and defining a plurality of light emitting areas including a first light emitting area, a second light emitting area, and a third light emitting area that are adjacent to each other; and a plurality of light emitting elements on the substrate, and including a first light emitting element in the first light emitting area, a second light emitting element in the second light emitting area, and a third light emitting element in the third light emitting area, wherein a spacing between the second light emitting area and the third light emitting area is greater than a spacing between the first light emitting area and the second light emitting area. According to the method, during a light emitting period in which the first light emitting element, the second light emitting element, and the third light emitting element emit light to express a white color, especially a standard white color, a first electrode of the third light emitting element is applied with a third voltage greater than a first voltage applied to a first electrode of the first light emitting element and a second voltage applied to a first electrode of the second light emitting element. The above and below features of the display panel, display device and electronic device may be incorporated into the method accordingly.

According to some embodiments of the present invention, a display panel, a display device and an electronic device may include a first light emitting element, a second light emitting element, and a third light emitting element disposed in a first light emitting area, a second light emitting area, and a third light emitting area, respectively. In some embodiments, a relatively greater voltage may be applied to the third light emitting element compared to a voltage applied to the first light emitting element and the second light emitting element, and a gap between the second light emitting area and the third light emitting area may be greater than a gap between the first light emitting area and the second light emitting area. Accordingly, it may be possible to secure an aperture ratio of the display panel, the display device and the electronic device, while reducing a leakage current between sub-pixels.

In some embodiments, the first light emitting element, the second light emitting element, and the third light emitting element may be a red light emitting element, a green light emitting element, and a blue light emitting element, respectively. According to some embodiments, a temperature stability of the display panel, the display device and the electronic device may be improved by lowering a temperature sensitivity of a second sub-pixel including the second light emitting element.

In some embodiments, the display panel, the display device and the electronic device may further include a separation structure disposed between the second light emitting area and the third light emitting area. Accordingly, a leakage current between the sub-pixels may be further reduced.

In some embodiments, the display panel, the display device and the electronic device may include connection holes for connecting light emitting elements and circuit elements of the sub-pixels to each other, and the connection holes may not be disposed between the first light emitting area and the second light emitting area, but may be disposed in another portion of a non-light emitting area. Accordingly, a design structure of the display panel, the display device and the electronic device may be improved, and the connection holes of the sub-pixels may be stably formed.

However, the present invention is not limited to the above aspects and features, and the above and additional aspects and features will be set forth, in part, in the detailed description that follows with reference to the drawings, and in part, may be apparent therefrom, or may be learned by practicing one or more of the presented embodiments of the present invention.

### BRIEF DESCRIPTION OF THE DRAWINGS

The above and other aspects and features of the present invention will be more clearly understood from the following detailed description of the illustrative, nonlimiting embodiments with reference to the accompanying drawings, in which:
FIG. 1 is a perspective view illustrating a display device according to an embodiment;
FIG. 2 is a perspective view illustrating a display module according to an embodiment;
FIG. 3 is a plan view illustrating a display panel according to an embodiment;
FIG. 4 is a cross-sectional view illustrating a display module according to an embodiment;
FIG. 5 is an equivalent circuit diagram illustrating a sub-pixel according to an embodiment;
FIG. 6 is an equivalent circuit diagram illustrating a sub-pixel according to an embodiment;
FIG. 7 is a plan view illustrating a display area of a display panel according to an embodiment;
FIG. 8 is a plan view illustrating a display area of a display panel according to an embodiment;
FIG. 9 is a cross-sectional view illustrating a display area of a display panel according to an embodiment;
FIG. 10 is an equivalent circuit diagram illustrating an operation during a light emitting period of a pixel according to an embodiment;
FIG. 11 is a graph illustrating voltage-current characteristics of light emitting elements included in sub-pixels according to an embodiment;
FIG. 12 is a plan view illustrating a display area of a display panel according to an embodiment;
FIG. 13 is a plan view illustrating positions of a light emitting area and connection holes in a non-light emitting area of a display panel according to an embodiment;
FIG. 14 is a plan view illustrating positions of a light emitting area and connection holes in a non-light emitting area of a display panel according to an embodiment;
FIG. 15 is a graph illustrating a color change of some sample display devices according to a temperature change;
FIG. 16 is a block diagram of an electronic device according to an embodiment; and
FIG. 17 illustrates schematic diagrams of some electronic devices according to some embodiments.

Hereinafter, embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present invention in its entirety, each suitable feature of the various embodiments of the present invention may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present invention should not be construed as being limited to the specific shapes shown in the figures, and should be construed considering changes in shapes that may occur, for example, as a result of manufacturing. As such, the shapes shown in the drawings may not depict the actual shapes of areas of the device, and the present invention is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present invention.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the spirit and scope of the example embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

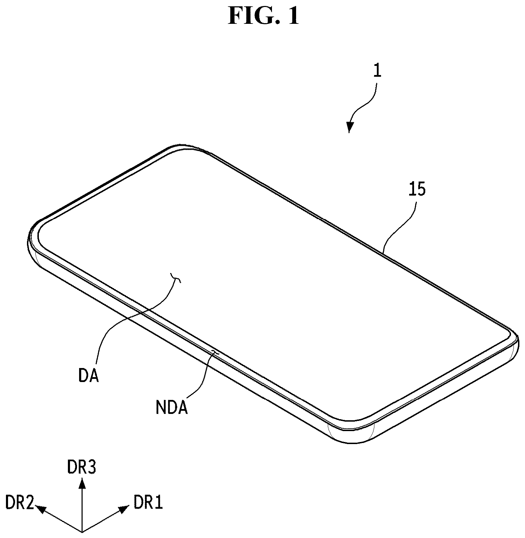

FIG. 1 is a perspective view illustrating a display device according to an embodiment.

Referring to FIG. 1, a display device 1 may be a device capable of providing an image, such as a moving image or still image. For example, the display device 1 may include a display module (e.g., a display or a touch-display) for implementing a display screen, and may be an electronic device capable of displaying an image. As another example, the display device 1 may be included in an electronic device for providing a display screen of the electronic device. As an example, the display device 1 may refer to any suitable electronic device (or a portion of the electronic device) that provides a display screen on which an image may be displayed, or includes the display module for displaying an image.

In an embodiment, the display device 1 may be a light emitting display device including a light emitting element, such as an inorganic light emitting diode or an organic light emitting diode, but the present invention is not limited thereto. For example, while a light emitting display device including an organic light emitting diode may be described in more detail as a display device 1 as an illustrative example, the kind or form of the display device 1 is not limited thereto.

In an embodiment, the display device 1 may further include additional elements in addition to the display module. For example, the display device 1 may further include a housing 15 (e.g., a case) for accommodating and/or protecting the display module. In FIG. 1, a portion of the display device 1 (e.g., a portion including a display area DA and a non-display area NDA) surrounded (e.g., around a periphery thereof) by the housing 15 may include the display module including a display panel, and may optionally further include a cover window disposed on the display panel.

The display device 1 may have various suitable shapes, such as a rectangular shape, a square shape, a circular shape, or other suitable shapes. The display device 1 may include corner portions having an angular shape or a rounded shape. FIG. 1 illustrates a display device 1 having a substantially rectangular shape on a plane defined by a first direction DR1 and a second direction DR2, and having corner portions of a rounded shape. The display device 1 may have a thickness in a third direction DR3 crossing or intersecting the first direction DR1 and the second direction DR2.

The display device 1 may include a display area DA and a non-display area NDA. The display area DA is an area in which an image may be displayed, and the non-display area NDA is an area in which an image is not displayed. The display area DA may also be referred to as an active area, and the non-display area NDA may also be referred to as a non-active area. The display area DA may generally occupy the center of the display device 1. The non-display area NDA may be disposed around the display area DA. As an example, the non-display area NDA may be disposed at an edge of the display device 1, and may surround (e.g., around a periphery of) the display area DA.

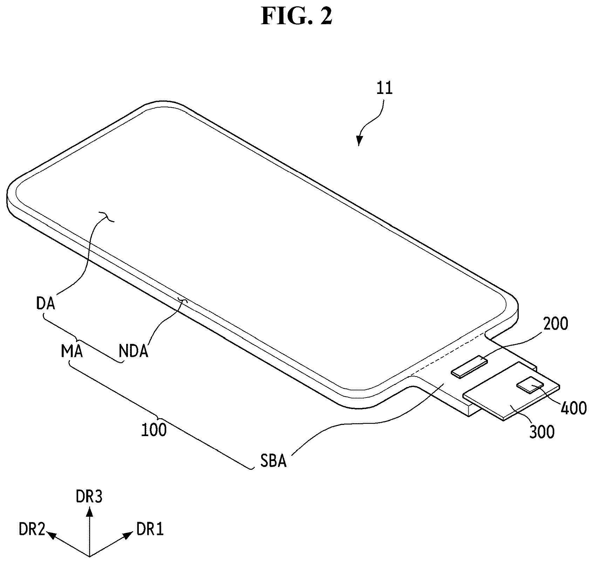

FIG. 2 is a perspective view illustrating a display module according to an embodiment. For example, FIG. 2 illustrates a display module (e.g., a display or a touch-display) 11 that may be included in the display device 1 of FIG. 1 according to an embodiment.

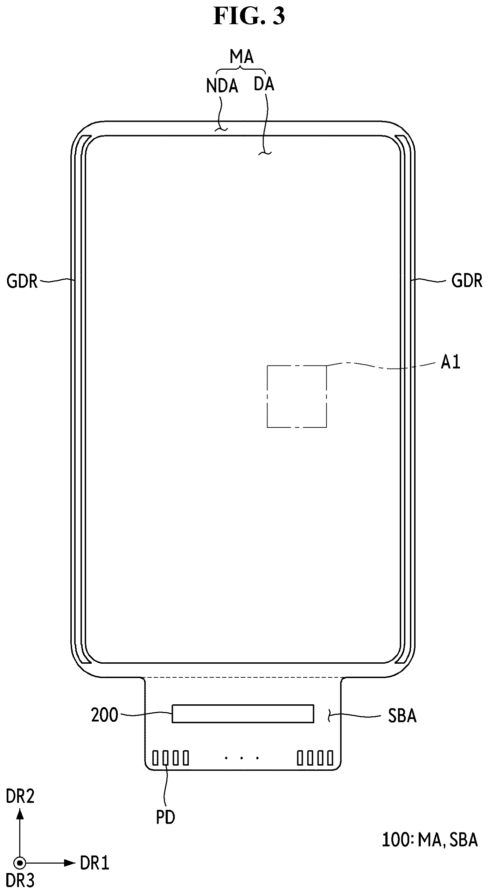

FIG. 3 is a plan view illustrating a display panel according to an embodiment. For example, FIG. 3 illustrates a display panel 100 that may be included in the display module 11 of FIG. 2 according to an embodiment.

In FIGS. 2 and 3, the display panel 100 including a sub-area SBA in a state in which the sub-area SBA of the display panel 100 is unfolded without being bent is illustrated. The display panel 100 may be accommodated inside the housing 15 (e.g., see FIG. 1) by being bent, so that at least a portion of the sub-area SBA overlaps with a main area MA.

Referring to FIGS. 1 to 3, the display device 1 may include the display module 11. The display module 11 may include the display panel 100 for implementing a display screen, and a display driver 200 and a circuit board 300 for driving the display panel 100. In an embodiment, the display device 1 may provide a touch input function, and the display module 11 may further include a touch driver 400.

The display panel 100 may include the main area MA including a display area DA. The main area MA may further include a non-display area NDA disposed around the display area DA.

In the display area DA, sub-pixels may be disposed, each emitting light of a desired color (e.g., a specific or predetermined color). A plurality of sub-pixels disposed adjacent to each other may form one pixel. For example, the sub-pixel may be the smallest unit that expresses an individual color. A pixel may be a group of sub-pixels that are the smallest unit that may express a white color, especially a standard white color (e.g., an achromatic color including white of the highest luminance and gray of a luminance lower than the highest luminance), and may include a plurality of sub-pixels that emit light of different colors from each other. As an example, red sub-pixels that emit red light, green sub-pixels that emit green light, and blue sub-pixels that emit blue light may be disposed in the display area DA. In this case, at least one red sub-pixel, at least one green sub-pixel, and at least one blue sub-pixel that are adjacent to each other may form one pixel. The pixel may express a variety of colors in addition to the white or standard white color. The kind, number, and/or ratio of the sub-pixels constituting each pixel may be variously modified as needed or desired.

Lines electrically connected to the sub-pixels in the display area DA may be disposed in the non-display area NDA. As an example, lines electrically connected between the sub-pixels and the display driver 200, and/or lines electrically connected between the sub-pixels and at least one pad PD, may be disposed in the non-display area NDA.

In an embodiment, at least one driving circuit for driving the sub-pixels may be further disposed in the non-display area NDA. For example, at least one gate driver GDR may be disposed in the non-display area NDA. FIG. 3 illustrates an embodiment in which two gate drivers GDR are disposed in the non-display area NDA on both sides (e.g., opposite sides) of the display area DA, but the number and/or the positions of the gate drivers GDR are not limited thereto. The gate driver GDR may supply gate signals to the sub-pixels through gate lines electrically connected to the sub-pixels.

In an embodiment, the gate driver GDR may be a panel-embedded driving circuit formed inside the display panel 100 together with the sub-pixels. As an example, the gate driver GDR may include circuit elements (e.g., transistors and capacitors included in stage circuits that generate gate signals for controlling an operation of the sub-pixels) formed within a backplane layer of the display panel 100 together with the circuit elements of the sub-pixels (e.g., transistors and capacitors included in pixel circuits of the sub-pixels).

In an embodiment, the display panel 100 may further include the sub-area SBA extending from the main area MA. In an embodiment, the sub-area SBA may have flexible characteristics to enable bending, folding, and/or rolling. When the sub-area SBA is bent (e.g., folded), at least a portion of the sub-area SBA and the main area MA may overlap with each other in the thickness direction (e.g., the third direction DR3). As an example, when the display panel 100 is bent in the sub-area SBA, at least a portion of the sub-area SBA may be disposed below (e.g., under) the main area MA.

The sub-area SBA may include the display driver 200 and the pad portion. The pad portion may be an area where pads PD electrically connected to the circuit board 300 are disposed. In addition, lines electrically connected to the sub-pixels, the display drivers 200, and/or the pads PD may be further disposed in the sub-area SBA.

In another embodiment, the sub-area SBA may be omitted as needed or desired, and the pad portion may be disposed in the non-display area NDA of the main area MA. In this case, the display driver 200 may be disposed in the non-display area NDA of the main area MA, or on the circuit board 300 connected to the display panel 100.

The display driver 200 may output driving signals for driving the display panel 100. The display driver 200 may include a data driver. The data driver of the display driver 200 may supply data voltages to the sub-pixels through data lines electrically connected to the sub-pixels.

In an embodiment, the display driver 200 may be formed as an integrated circuit (IC), and mounted on the display panel 100 in a chip on glass (COG) method, a chip on plastic (COP) method, or an ultrasonic bonding method. However, the present invention is not limited thereto. As an example, the display driver 200 may be disposed on the circuit board 300 in a chip on film (COF) method, and electrically connected to the display panel 100 through the pad portion.

In an embodiment, the display driver 200 may further include a power supply unit (e.g., a power supply circuit) that generates driving voltages used for driving the pixels PX, and may supply the driving voltages to power lines electrically connected to the pixels PX. In another embodiment, the power supply unit may be provided separately from the display driver 200, and may be electrically connected to the display panel 100 through the pads PD. As an example, the power supply unit may be disposed on the circuit board 300, or on another circuit board electrically connected to the circuit board 300.

In an embodiment, the display driver 200 may further include a timing controller that outputs driving signals used for driving the gate driver GDR and the data driver. The timing controller may supply the driving signals (e.g., gate control signals and data control signals) to drive the gate driver GDR and the data driver. In another embodiment, the timing controller may be provided separately from the display driver 200, and may be electrically connected to the display panel 100 through the pads PD. As an example, the timing controller may be disposed on the circuit board 300, or on another circuit board electrically connected to the circuit board 300.

The circuit board 300 may be disposed on the pad portion of the display panel 100, and may be electrically connected to the display panel 100 through a conductive material (e.g., an anisotropic conductive film (ACF) or the like). As an example, the circuit board 300 may be attached onto the pads PD of the display panel 100 using an anisotropic conductive film (ACF). In an embodiment, the circuit board 300 may be a flexible film such as a flexible printed circuit board, a printed circuit board, or a chip on film.

The touch driver 400 may be mounted on the circuit board 300. The touch driver 400 may be electrically connected to a touch sensing layer of the display panel 100. In an embodiment, the touch sensing layer of the display panel 100 may include touch electrodes constituting a capacitive-kind of touch sensor. In this case, the touch driver 400 may supply a touch driving signal to each of the touch electrodes of the touch sensing layer, and may detect a touch input by sensing an amount of change in a capacitance formed between the touch electrodes. In an embodiment, the touch driver 400 may be formed as an integrated circuit (IC).

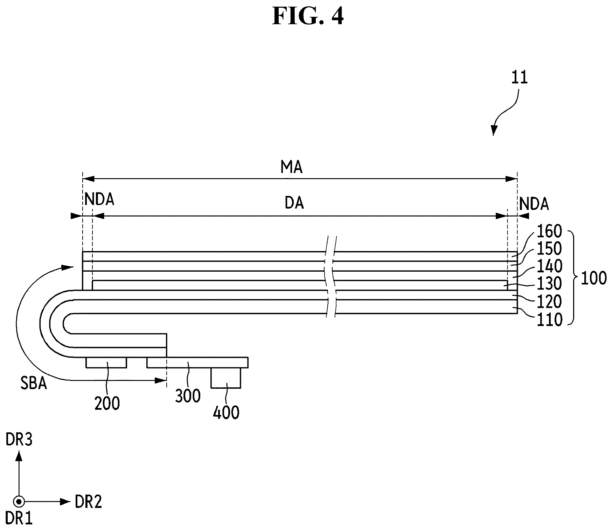

FIG. 4 is a cross-sectional view illustrating the display module according to an embodiment. For example, FIG. 4 schematically illustrates an example of a cross-section of the display module 11 in a state in which the display panel 100 of FIGS. 2 and 3 is bent in the sub-area SBA.

Referring to FIGS. 2 and 4, the display panel 100 may include a substrate 110, a backplane layer 120, a light emitting element layer 130, and an encapsulation layer 140 (e.g., a protective layer). In an embodiment, the display panel 100 may further include at least one of a touch sensing layer 150 and/or an optical layer 160.

The substrate 110 is a basic structure of the display panel 100, and may support the backplane layer 120 and the light emitting element layer 130, or the like. The substrate 110 may be a flexible substrate capable of being bent, folded, rolled, and/or the like, but the present invention is not limited thereto. In an embodiment, the substrate 110 may include a polymer resin, such as polyimide (PI). In another embodiment, the substrate 110 may include a glass material or a metal material.

The backplane layer 120 may be disposed on the substrate 110. The backplane layer 120 may be disposed in the display area DA and the non-display area NDA. When the display panel 100 further includes the sub-area SBA, the backplane layer 120 may also be disposed in the sub-area SBA.

The backplane layer 120 may include circuit elements of the sub-pixels, and lines electrically connected to the sub-pixels. For example, the backplane layer 120 may include transistors and capacitors included in the pixel circuits of the sub-pixels, and signal lines (e.g., gate lines and data lines) and power lines (e.g., a plurality of power lines including a first power line and a second power line for transmitting a high-potential first driving voltage and a low-potential second driving voltage, respectively) electrically connected to the sub-pixels. In an embodiment, when the display panel 100 includes the gate driver GDR disposed in the non-display area NDA, the backplane layer 120 may further include circuit elements included in the gate driver GDR, and lines electrically connected to the gate driver GDR.

The light emitting element layer 130 may be disposed on the backplane layer 120. The light emitting element layer 130 may be disposed in at least the display area DA. The light emitting element layer 130 may include a structure (e.g., a pixel defining layer or a bank) that defines or partitions light emitting areas of the sub-pixels, and light emitting elements disposed in the light emitting areas of the sub-pixels.

The encapsulation layer 140 may be disposed on the light emitting element layer 130. For example, the encapsulation layer 140 may cover upper and side surfaces of the light emitting element layer 130 to protect the light emitting element layer 130. The encapsulation layer 140 may be disposed in at least the display area DA. An end of the encapsulation layer 140 may be disposed in the non-display area NDA. In an embodiment, the encapsulation layer 140 may include a plurality of inorganic encapsulation layers, and an organic encapsulation layer disposed or interposed between the inorganic encapsulation layers.

The touch sensing layer 150 may be disposed on the encapsulation layer 140. For example, the touch sensing layer 150 may be disposed or formed on the encapsulation layer 140, or may be disposed on a separate substrate that is disposed on the encapsulation layer 140. The position of the touch sensing layer 150 is not limited to that illustrated in FIG. 4, and may be variously modified as needed or desired. When the display module 11 (or the display device 1) does not provide the touch input function, the display module 11 may not include the touch sensing layer 150. As another example, the touch sensing layer 150 may be provided separately from the display panel 100, and disposed on the display panel 100.

The touch sensing layer 150 may include elements for generating an electrical signal in response to a user's touch input. For example, the touch sensing layer 150 may include touch electrodes disposed in an area that provides a touch input function, and touch lines that electrically connect the touch electrodes and the touch driver 400 to each other. When the display module 11 provides the touch input function in the display area DA, the touch electrodes may be disposed in the display area DA. The touch lines may be connected to the touch electrodes in the main area MA (e.g., the display area DA) in which the touch electrodes are disposed. In an embodiment, the touch lines may extend to the sub-area SBA, and may be electrically connected to a plurality of pads PD disposed in the pad portion. In this case, the touch lines may be electrically connected to the touch driver 400 through the plurality of pads PD.

The optical layer 160 may include elements for adjusting and/or improving optical characteristics of the display panel 100. As an example, the optical layer 160 may include at least one of a color filter layer (e.g., a color filter layer including color filters that selectively transmit light corresponding to each light emitting wavelength of each of the sub-pixels), a polarizing layer, and/or an anti-reflection layer. The optical layer 160 may be provided integrally with the display panel 100, but the present invention is not limited thereto. The optical layer 160 may also be omitted as needed or desired.

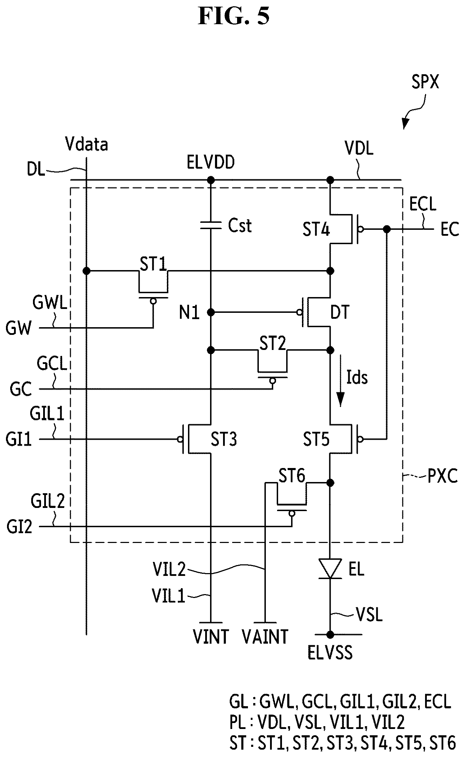

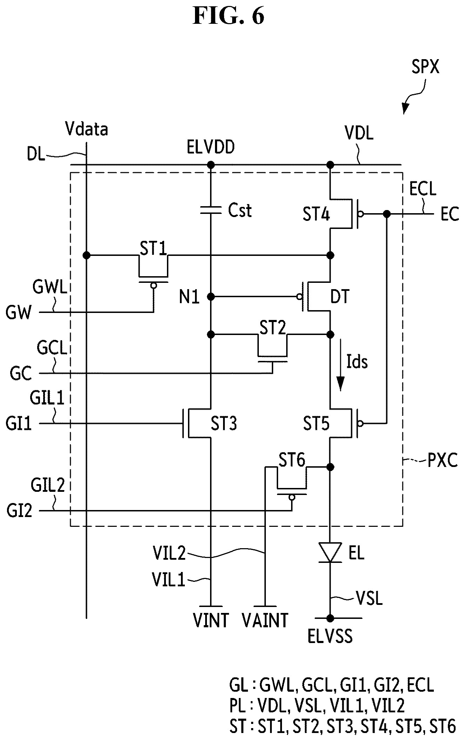

FIG. 5 is an equivalent circuit diagram illustrating a sub-pixel according to an embodiment. FIG. 6 is an equivalent circuit diagram illustrating a sub-pixel according to an embodiment.

FIGS. 5 and 6 illustrate different embodiments of one sub-pixel SPX that may be included in the display panel 100 of FIGS. 2 to 4. For example, FIG. 5 illustrates an example of a sub-pixel SPX that includes homogeneous transistors (e.g., P-type transistors), and FIG. 6 illustrates an example of a sub-pixel SPX that includes heterogeneous transistors (e.g., P-type and N-type transistors). However, the present invention is not limited to the embodiments of the sub-pixels SPX illustrated in FIGS. 5 and 6, and the structure and the operation method of the sub-pixel SPX may be variously modified as needed or desired.

In an embodiment, the circuit configurations of sub-pixels SPX that emit light of different colors from each other may be the same or substantially the same as each other. For example, the equivalent circuit diagrams of the red sub-pixel, the green sub-pixel, and the blue sub-pixel constituting one pixel may be the same or substantially the same as each other.

Referring to FIGS. 5 and 6 in addition to FIGS. 1 to 4, the sub-pixel SPX may be electrically connected to a plurality of signal lines including at least one gate line GL and a data line DL. For example, the sub-pixel SPX may be electrically connected to a plurality of gate lines GL including a first gate line GWL (e.g., a write scan line), a second gate line GCL (e.g., a control scan line), a third gate line GIL1 (e.g., a first initialization scan line), a fourth gate line GIL2 (e.g., a second initialization scan line), and a fifth gate line ECL (e.g., an emission control line), and the data line DL. The sub-pixel SPX may be electrically connected to the gate driver GDR through the gate lines GL. The kind and number of signal lines electrically connected to the sub-pixel SPX may be variously modified depending on the circuit configuration and the operating method of the sub-pixel SPX.

The gate driver GDR may output a write scan signal GW, a control scan signal GC, a first initialization scan signal GI1, a second initialization scan signal GI2, and an emission control signal EC to the first gate line GWL, the second gate line GCL, the third gate line GIL1, the fourth gate line GIL2, and the fifth gate line ECL, respectively. The display driver 200 may output a data voltage Vdata (e.g., a data voltage Vdata corresponding to image data of each frame) to the data line DL.

In addition, the sub-pixel SPX may be electrically connected to a plurality of power lines PL. For example, the sub-pixel SPX may be electrically connected to a first power line VDL (e.g., a first pixel power line), a second power line VSL (e.g., a second pixel power line), a third power line VIL1 (e.g., a first initialization power line), and a fourth power line VIL2 (e.g., a second initialization power line). The sub-pixel SPX may be electrically connected to a power supply circuit (e.g., a power supply circuit included in the display driver 200, or a power supply circuit disposed on the circuit board 300 or included in a separate power module) through the first power line VDL, the second power line VSL, the third power line VIL1, and the fourth power line VIL2. The kind and number of power lines electrically connected to the sub-pixel SPX may be variously modified depending on the circuit configuration and the operating method of the sub-pixel SPX.

The power supply circuit may supply a first driving voltage ELVDD, a second driving voltage ELVSS, a third driving voltage VINT, and a fourth driving voltage VAINT to the first power line VDL, the second power line VSL, the third power line VIL1, and the fourth power line VIL2, respectively. In an embodiment, the first driving voltage ELVDD, the second driving voltage ELVSS, the third driving voltage VINT, and the fourth driving voltage VAINT may be a high-potential pixel voltage (e.g., an anode voltage), a low-potential pixel voltage (e.g., a cathode voltage or a common voltage), a first initialization voltage (e.g., a gate initialization voltage), and a second initialization voltage (e.g., an anode initialization voltage), respectively.

The sub-pixel SPX may include a pixel circuit PXC and a light emitting element EL. The pixel circuit PXC and the light emitting element EL may be electrically connected to each other between the first power line VDL and the second power line VSL.

The pixel circuit PXC may control a driving current Ids supplied to the light emitting element EL, in response to the gate signals supplied to the sub-pixel SPX (e.g., the write scan signal GW, the control scan signal GC, the first initialization scan signal GI1, the second initialization scan signal GI2, and the emission control signal EC) and the data voltage Vdata. The pixel circuit PXC may control a light emission of the light emitting element EL.

The pixel circuit PXC may include a plurality of transistors and at least one capacitor. As an example, the pixel circuit PXC may include a driving transistor DT, at least one switching transistor ST, and a storage capacitor Cst. In an embodiment, the pixel circuit PXC may include first to sixth switching transistors ST1 to ST6. However, the structure of the pixel circuit PXC is not limited to the embodiments illustrated in FIGS. 5 and 6, and the kinds and/or numbers of circuit elements included in the pixel circuit PXC may be variously modified as needed or desired. As an example, the pixel circuit PXC may further include at least one transistor for compensating for hysteresis characteristics of the driving transistor DT and the like.

The driving transistor DT may be electrically connected between the first power line VDL and the light emitting element EL. For example, the driving transistor DT may be electrically connected to the first power line VDL via the fourth switching transistor ST4, and may be electrically connected to the light emitting element EL via the fifth switching transistor ST5. A gate electrode of the driving transistor DT may be electrically connected to a first node N1. The driving transistor DT may control the driving current Ids flowing into the sub-pixel SPX according to a voltage of the first node N1 (e.g., a voltage corresponding to the data voltage Vdata).

The first switching transistor ST1 may be electrically connected between the data line DL and a first electrode of the driving transistor DT (e.g., a source electrode or a source region of the driving transistor DT). A gate electrode of the first switching transistor ST1 may be electrically connected to the first gate line GWL. The first switching transistor ST1 may be turned on by a write scan signal GW of a gate-on voltage (e.g., a low-level voltage at which the first switching transistor ST1 may be turned on) that is supplied from the first gate line GWL. When the first switching transistor ST1 is turned on, the data voltage Vdata supplied from the data line DL may be transmitted to the first electrode of the driving transistor DT.

The second switching transistor ST2 may be electrically connected between a second electrode of the driving transistor DT (e.g., a drain electrode or a drain region of the driving transistor DT) and the first node N1. A gate electrode of the second switching transistor ST2 may be electrically connected to the second gate line GCL. The second switching transistor ST2 may be turned on by a control scan signal GC of a gate-on voltage (e.g., a low-level or a high-level voltage at which the second switching transistor ST2 may be turned on) that is supplied from the second gate line GCL, and may connect the gate electrode and the second electrode of the driving transistor DT to each other. When the second switching transistor ST2 is turned on, the driving transistor DT may be driven as a diode (e.g., may be diode-connected), and a voltage corresponding to the data voltage Vdata may be applied to the first node N1.

The third switching transistor ST3 may be electrically connected between the first node N1 and the third power line VIL1. A gate electrode of the third switching transistor ST3 may be electrically connected to the third gate line GIL1. The third switching transistor ST3 may be turned on by an initialization scan signal GI of a gate-on voltage (e.g., a low-level or a high-level voltage at which the third switching transistor ST3 may be turned on) that is supplied from the third gate line GIL1, and may connect the first node N1 to the third power line VIL1. When the third switching transistor ST3 is turned on, a voltage of the first node N1 may be initialized to the third driving voltage VINT of the third power line VIL1.

The fourth switching transistor ST4 may be electrically connected between the first power line VDL and the first electrode of the driving transistor DT. A gate electrode of the fourth switching transistor ST4 may be electrically connected to the fifth gate line ECL. The fourth switching transistor ST4 may be turned on by an emission control signal EC of a gate-on voltage (e.g., a low-level voltage at which the fourth switching transistor ST4 may be turned on) that is supplied from the fifth gate line ECL, and may connect the first electrode of the driving transistor DT to the first power line VDL.

The fifth switching transistor ST5 may be electrically connected between the second electrode of the driving transistor DT and the light emitting element EL. A gate electrode of the fifth switching transistor ST5 may be electrically connected to the fifth gate line ECL. The fifth switching transistor ST5 may be turned on by an emission control signal EC of a gate-on voltage (e.g., a low-level voltage at which the fifth switching transistor ST5 may be turned on) that is supplied from the fifth gate line ECL, and may connect the second electrode of the driving transistor DT to the light emitting element EL.

A period during which the fourth switching transistor ST4 and the fifth switching transistor ST5 are turned on may include a light emitting period of the sub-pixel SPX. During the light emitting period of the sub-pixel SPX, the driving current Ids controlled by the driving transistor DT may flow through the light emitting element EL.

The sixth switching transistor ST6 may be electrically connected between a first electrode (e.g., an anode electrode) of the light emitting element EL and the fourth power line VIL2. A gate electrode of the sixth switching transistor ST6 may be electrically connected to the fourth gate line GIL2. The sixth switching transistor ST6 may be turned on by a second initialization scan signal GI2 of a gate-on voltage (e.g., a low-level voltage at which the sixth switching transistor ST6 may be turned on) that is supplied from the fourth gate line GIL2, and may connect the first electrode of the light emitting element EL to the fourth power line VIL2. When the sixth switching transistor ST6 is turned on, a voltage of the first electrode of the light emitting element EL may be initialized to the fourth driving voltage VAINT of the fourth power line VIL2.

Each of the transistors of the sub-pixel SPX may be formed as a P-type transistor or an N-type transistor, taking into consideration operating characteristics desired for the transistor, a design structure of the display panel 100, and/or a manufacturing efficiency.

In an embodiment, the sub-pixel SPX may include homogeneous transistors. As an example, as illustrated in FIG. 5, the driving transistor DT and the switching transistors ST included in the pixel circuit PXC of the sub-pixel SPX may all be P-type transistors (e.g., P-type transistors including a low-temperature polycrystalline silicon).

In another embodiment, the sub-pixel SPX may include heterogeneous transistors. As an example, as illustrated in FIG. 6, the driving transistor DT and the first, fourth, fifth, and sixth switching transistors ST1, ST4, ST5, and ST6 may be P-type transistors (e.g., P-type transistors including a low-temperature polycrystalline silicon), and the second and third switching transistors ST2 and ST3 may be N-type transistors (e.g., N-type transistors including an oxide semiconductor).

The storage capacitor Cst may be connected between the first node N1 and the first power line VDL. The storage capacitor Cst may be charged with a voltage corresponding to the data voltage Vdata that is applied to the first node N1.

The light emitting element EL may be electrically connected between the pixel circuit PXC and the second power line VSL. For example, the first electrode (e.g., an anode electrode or a pixel electrode) of the light emitting element EL may be electrically connected to a node between the fifth switching transistor ST5 and the sixth switching transistor ST6, and a second electrode (e.g., a cathode electrode or a common electrode) of the light emitting element EL may be electrically connected to the second power line VSL. The light emitting element EL may emit light having a luminance corresponding to the driving current Ids during the light emitting period of the sub-pixel SPX.

In an embodiment, the light emitting element EL may be an organic light emitting diode (OLED) including an organic light emitting layer. However, the present invention is not limited thereto. For example, the light emitting element EL may be another kind of light emitting element, such as a quantum dot LED including a quantum dot light emitting layer, an inorganic LED including an inorganic semiconductor, a micro LED, or a nano LED.

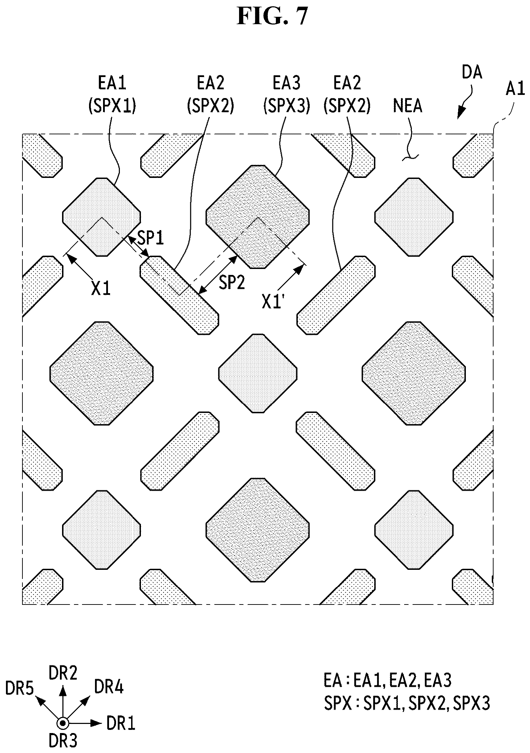

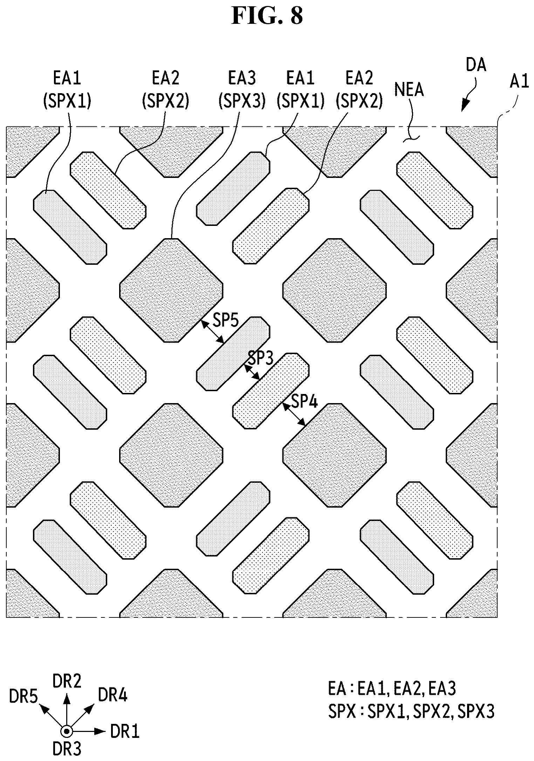

FIG. 7 is a plan view illustrating a display area of a display panel according to an embodiment. FIG. 8 is a plan view illustrating a display area of a display panel according to an embodiment. For example, FIGS. 7 and 8 illustrate different embodiments of a portion of the display area DA corresponding to the area A1 of FIG. 3.

Referring to FIGS. 7 and 8 in addition to FIGS. 1 to 6, sub-pixels SPX may be disposed in the display area DA. Each sub-pixel SPX may include a light emitting area EA in which a light emitting element EL is disposed, and may emit light of a desired color (e.g., a specific or predetermined color) from the light emitting area EA.

The display panel 100 according to an embodiment may include first sub-pixels SPX1 that emit light of a first color in first light emitting areas EA1, second sub-pixels SPX2 that emit light of a second color in second light emitting areas EA2, and third sub-pixels SPX3 that emit light of a third color in third light emitting areas EA3. The first light emitting area EA1 may refer to a light emitting area EA of the first sub-pixel SPX1, the second light emitting area EA2 may refer to a light emitting area EA of the second sub-pixel SPX2, and the third light emitting area EA3 may refer to a light emitting area EA of the third sub-pixel SPX3. A plurality of light emitting areas EA including the first light emitting areas EA1 of the first sub-pixels SPX1, the second light emitting areas EA2 of the second sub-pixels SPX2, and the third light emitting areas EA3 of the third sub-pixels SPX3 may be disposed in the display area DA.

In an embodiment, the light of the first color, the light of the second color, and the light of the third color may be red light, green light, and blue light, respectively. As an example, the light of the first color may be light in a red wavelength band having a main peak wavelength in the range of approximately 600 nm to 750 nm. The light of the second color may be light in a green wavelength band having a main peak wavelength in the range of approximately 480 nm to 560 nm. The light of the third color may be light in a blue wavelength band having a main peak wavelength in the range of approximately 370 nm to 460 nm. In this case, the first sub-pixels SPX1 may be red sub-pixels that emit red light, the second sub-pixels SPX2 may be green sub-pixels that emit green light, and the third sub-pixels SPX3 may be blue sub-pixels that emit blue light.

At least one first sub-pixel SPX1, at least one second sub-pixel SPX2, and at least one third sub-pixel SPX3 that are disposed adjacent to each other in the display area DA may form one pixel. In an embodiment, the display panel 100 may include different numbers of first sub-pixels SPX1, second sub-pixels SPX2, and/or third sub-pixels SPX3 from each other. As an example, the display panel 100 may include a number of second sub-pixels SPX2 that is twice the number of each of the first sub-pixels SPX1 and the third sub-pixels SPX3, as illustrated in FIG. 7. In this case, one first sub-pixel SPX1, two second sub-pixels SPX2, and one third sub-pixel SPX3 that are adjacent to each other may form one pixel. In another embodiment, the display panel 100 may include the same number of first sub-pixels SPX1, second sub-pixels SPX2, and third sub-pixels SPX3 as each other, as illustrated in FIG. 8. In this case, one first sub-pixel SPX1, one second sub-pixels SPX2, and one third sub-pixel SPX3 that are adjacent to each other may form one pixel.

The number, ratio, and/or arrangement structure of the first sub-pixels SPX1, the second sub-pixels SPX2, and the third sub-pixels SPX3 disposed in the display area DA are not limited to the embodiments illustrated in FIGS. 7 and 8, and may be variously modified as needed or desired. In addition, the kind, number, and/or ratio of sub-pixels SPX forming each pixel may also be variously modified as needed or desired.

In an embodiment, each light emitting area EA may have a roughly quadrangular planar shape. For example, each light emitting area EA may have a planar shape, such as a rectangle, a square, or a rhombus. However, the present invention is not limited thereto, and each light emitting area EA may have a non-quadrangular planar shape, such as a circle, an ellipse, or other suitable polygons.

In an embodiment, the first light emitting area EA1, the second light emitting area EA2, and the third light emitting area EA3 may have different sizes (e.g., areas) from each other. For example, the sizes of the light emitting areas EA of the sub-pixels SPX may be differentiated depending on a light emitting efficiency or a luminance ratio of the sub-pixels SPX. As an example, as illustrated in FIG. 7, the size of one first light emitting area EA1 may be greater than the size of one second light emitting area EA2, and smaller than the size of one third light emitting area EA3. As another example, as illustrated in FIG. 8, the size of one second light emitting area EA2 may be greater than the size of one first light emitting area EA1, and smaller than the size of one third light emitting area EA3.

In the embodiment illustrated in FIG. 7, each of the first light emitting area EA1 and the third light emitting area EA3 may have a rhombus shape with chamfered vertices, and the second light emitting area EA2 may have a rectangular or elliptical shape extending in a fourth direction DR4 or a fifth direction DR5 and with chamfered vertices. In the embodiment illustrated in FIG. 8, the third light emitting area EA3 may have a rhombus shape with chamfered vertices, and each of the first light emitting area EA1 and the second light emitting area EA2 may have a rectangular or elliptical shape extending in the fourth direction DR4 or the fifth direction DR5 and with chamfered vertices.

The fourth direction DR4 may be a diagonal direction extending between the first direction DR1 and the second direction DR2. As an example, the fourth direction DR4 may form an angle of 45° with each of the first direction DR1 and the second direction DR2, but the present invention is not limited thereto. The fifth direction DR5 may be a diagonal direction extending between an opposite direction of the first direction DR1 and the second direction DR2. For example, the fifth direction DR5 may form an angle of 90° with the fourth direction DR4, but the present invention is not limited thereto.

In the embodiment illustrated in FIG. 7, the first light emitting areas EA1 and the third light emitting areas EA3 may be alternately disposed along the first direction DR1 and the second direction DR2. The second light emitting areas EA2 may be sequentially or continuously disposed along the first direction DR1 and the second direction DR2. The second light emitting areas EA2 may be disposed between the first light emitting areas EA1 that are adjacent to each other, and between the third light emitting areas EA3 that are adjacent to each other, along the fourth direction DR4 and the fifth direction DR5. For example, some of the second light emitting areas EA2 may have a shape extending in the fourth direction DR4, may be alternately disposed with the first light emitting areas EA1 along the fourth direction DR4, and may be alternately disposed with the third light emitting areas EA3 along the fifth direction DR5. In addition, others of the second light emitting areas EA2 may have a shape extending in the fifth direction DR5, may be alternately disposed with the third light emitting areas EA3 along the fourth direction DR4, and may be alternately disposed with the first light emitting areas EA1 along the fifth direction DR5. The second light emitting areas EA2 may have a shape extending in a direction toward the first light emitting areas EA1. As an example, short sides of the second light emitting areas EA2 may face the first light emitting areas EA1, and long sides of the second light emitting areas EA2 may face the third light emitting areas EA3.

In the embodiment illustrated in FIG. 8, a pair of first light emitting area EA1 and second light emitting area EA2 extending in the same direction as each other may be adjacent to each other in the fourth direction DR4 or the fifth direction DR5. The third light emitting areas EA3 may be sequentially or continuously disposed along the first direction DR1 and the second direction DR2. In each of the fourth direction DR4 and the fifth direction DR5, a pair of first light emitting area EA1 and second light emitting area EA2 may be disposed between the third light emitting areas EA3. In addition, in each of the fourth direction DR4 and the fifth direction DR5, the first light emitting area EA1 and the second light emitting area EA2 extending in the fourth direction DR4 and the first light emitting area EA1 and the second light emitting area EA2 extending in the fifth direction DR5 may be alternately disposed.

FIGS. 7 and 8 illustrate some embodiments related to the shape or arrangement of the light emitting areas EA, but the present invention is not limited thereto. For example, the shape, size, number, and/or arrangement structure of each of the light emitting areas EA disposed in the display area DA may be variously modified as needed or desired.

The display area DA may further include a non-light emitting area NEA around the light emitting areas EA. The non-light emitting area NEA may surround (e.g., around a periphery of) each of the light emitting areas EA, and may be disposed between the light emitting areas EA. The light emitting areas EA that are adjacent to each other may be spaced from each other with a portion of the non-light emitting area NEA disposed or interposed therebetween.

In some embodiments, the first light emitting areas EA1 and the second light emitting areas EA2 may be disposed relatively closer to each other, and the second light emitting areas EA2 and the third light emitting areas EA3 may be disposed relatively farther from each other. For example, in the embodiment illustrated in FIG. 7, one second light emitting area EA2 may be spaced apart from the first light emitting area EA1 that is adjacent thereto by a first spacing SP1 (e.g., a first distance), and may be spaced apart from the third light emitting area EA3 that is adjacent thereto by a second spacing SP2 (e.g., a second distance) greater than the first spacing SP1. In the embodiment illustrated in FIG. 8, one second light emitting area EA2 may be spaced apart from the first light emitting area EA1 that is adjacent thereto by a third spacing SP3 (e.g., a third distance), and may be spaced apart from the third light emitting area EA3 that is adjacent thereto by a fourth spacing SP4 (e.g., a fourth distance) greater than the third spacing SP3. In addition, in the embodiment illustrated in FIG. 8, the first light emitting area EA1 and the third light emitting area EA3 that are adjacent to each other may be spaced apart from each other by a fifth spacing SP5 (e.g., a fifth distance) greater than the third spacing SP3. The fourth spacing SP4 and the fifth spacing SP5 may be the same or substantially the same as each other (or similar to each other).

In some embodiments, the spacing between the light emitting areas EA may be variously adjusted and/or differentiated depending on a difference in a voltage applied to the light emitting elements EL disposed in each light emitting area EA. For example, in some embodiments, a spacing between the light emitting areas EA of the sub-pixels SPX where a difference in the driving voltage applied to the light emitting elements EL of the sub-pixels SPX during the light emitting period of the sub-pixels SPX (e.g., a difference in the voltage applied to the first electrode of each of the light emitting elements EL of the first sub-pixel SPX1, the second sub-pixel SPX2, and the third sub-pixel SPX3) is relatively larger may be expanded, and a spacing between the light emitting areas EA of the sub-pixels SPX where the difference in the voltage applied to each light emitting element EL is relatively smaller may be reduced. Accordingly, a leakage current between the sub-pixels SPX may be effectively reduced or prevented without reducing the area (e.g., the aperture ratio) of the light emitting areas EA.

For example, the light emitting element EL of the second sub-pixel SPX2 disposed in the second light emitting area EA2 may be a high-efficiency green light emitting element (e.g., a green organic light emitting diode) that is driven with a relatively lower driving current Ids compared to those of the light emitting element EL of the first sub-pixel SPX1 disposed in the first light emitting area EA1 and the light emitting element EL of the third sub-pixel SPX3 disposed in the third light emitting area EA3. On the other hand, the light emitting element EL of the third sub-pixel SPX3 may be a low-efficiency blue light emitting element (e.g., a blue organic light emitting diode) that is driven with a relatively higher driving current Ids compared to those of the light emitting element EL of the first sub-pixel SPX1 and the light emitting element EL of the second sub-pixel SPX2. The light emitting element EL of the first sub-pixel SPX1 may be a middle-efficiency red light emitting element (e.g., a red organic light emitting diode) that is driven with a relatively higher driving current Ids compared to that of the light emitting element EL of the second sub-pixel SPX2, and that is driven with a relatively lower driving current Ids compared to that of the light emitting element EL of the third sub-pixel SPX3.

In this case, because a difference between the voltage applied to the light emitting element EL of the third sub-pixel SPX3 and the voltage applied to the light emitting element EL of the second sub-pixel SPX2 is larger, it may be easy for a leakage current to occur between the second sub-pixel SPX2 and the third sub-pixel SPX3 (e.g., a lateral leakage current flowing from the third sub-pixel SPX3 to the second sub-pixel SPX2). In more detail, during the period in which the sub-pixels SPX are driven with a fine driving current Ids in response to a low-gradation image data, a relatively larger leakage current may occur, which may cause a change in a luminance or a color of the sub-pixels SPX and the pixel including the same. On the other hand, when the spacing between the second light emitting area EA2 and the third light emitting area EA3 (e.g., the second spacing SP2 in FIG. 7 or the fourth spacing SP4 in FIG. 8) is increased as in some embodiments, the leakage current between the second sub-pixel SPX2 and the third sub-pixel SPX3 may be effectively reduced. Accordingly, it may be possible to reduce or prevent the change in the luminance or the color of the sub-pixels SPX and the pixel including the same, and an image quality and a reliability of the display device 1 may be improved.

In an embodiment, the spacing between the light emitting areas EA may be variously modified and/or optimized taking into account the manufacturing process capability and aperture ratio of the display device 1. For example, the spacing between the first light emitting area EA1 and the second light emitting area EA2 that are adjacent to each other (e.g., the first spacing SP1 in FIG. 7 or the third spacing SP3 in FIG. 8) may be reduced or minimized within a range in which the manufacturing process capability of the display device 1 is secured. As an example, when a minimum spacing between the light emitting areas EA that may be reduced depending on a process capability of the display device 1 is approximately 15 µm, the spacing between the first light emitting area EA1 and the second light emitting area EA2 that are adjacent to each other may be formed (e.g., set to) a value between approximately 15 µm and 17 µm. The spacing between the second light emitting area EA2 and the third light emitting area EA3 that are adjacent to each other (e.g., the second spacing SP2 in FIG. 7 or the fourth spacing SP4 in FIG. 8) may be increased or maximized within a range that does not lower the aperture ratio of the display device 1. For example, the spacing between the second light emitting area EA2 and the third light emitting area EA3 may be increased by reducing a width of the second light emitting area EA2 in a short side direction, as much as possible to compensate for a loss in the area of the second light emitting area EA2 by increasing a length of the second light emitting area EA2 in a long side direction within the range where the minimum spacing between the first light emitting area EA1 and the second light emitting area EA2 is secured. As an example, the spacing between the first light emitting area EA1 and the second light emitting area EA2 may be reduced to a value between approximately 15 µm and 17 µm, and the spacing between the second light emitting area EA2 and the third light emitting area EA3 may be increased to a value between approximately 21 µm and 23 µm. Accordingly, the area of the second light emitting area EA2 may be secured (e.g., maintained to a substantially same or similar degree), while increasing the spacing between the second light emitting area EA2 and the third light emitting area EA3.

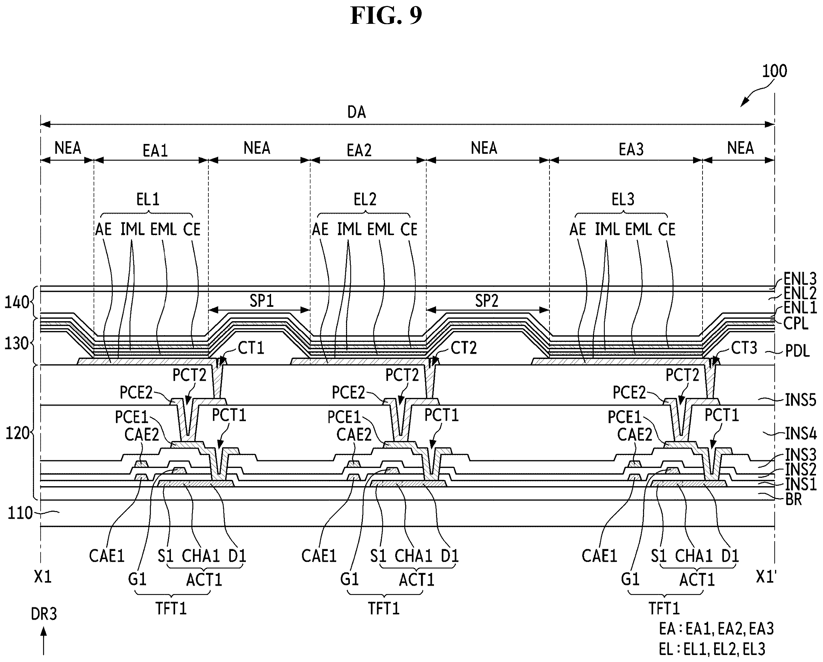

FIG. 9 is a cross-sectional view illustrating a display area of a display panel according to an embodiment. For example, FIG. 9 illustrates an embodiment of a cross section of the display panel 100 for a portion of the display area DA corresponding to the line X1 to X1' in FIG. 7.

Referring to FIGS. 1 and 9, the display panel 100 may include a substrate 110, and a backplane layer 120, a light emitting element layer 130, and an encapsulation layer 140 disposed on the substrate 110. In an embodiment, the display panel 100 may further include at least one of the touch sensing layer 150 and/or the optical layer 160 of FIG. 4.

The substrate 110 is a base member for forming the display panel 100, and may be formed as a single layer or multi-layers. In an embodiment, the substrate 110 may be a flexible substrate that includes a flexible material, such as a polymer resin, and capable of being deformed, such as bending, folding, and/or rolling, but the present invention is not limited thereto. The substrate 110 may be a rigid substrate including a hard or a rigid material, such as glass.

The substrate 110 may include a display area DA and a non-display area NDA. The display area DA may include light emitting areas EA in which light emitting elements EL of the sub-pixels SPX are disposed, and a non-light emitting area NEA around the light emitting areas EA.

The backplane layer 120 may be disposed on the substrate 110. The backplane layer 120 may include circuit elements included in the pixel circuits PXC of the sub-pixels SPX, and lines electrically connected to the sub-pixels SPX. As an example, the backplane layer 120 may include the driving transistor DT, the switching transistors ST, the storage capacitor Cst, the gate lines GL, the data lines DL, and the power lines PL as illustrated in FIG. 5 or 6. The backplane layer 120 may further include pads PD electrically connected to the lines (e.g., the pads PD disposed in the sub-area SBA in FIG. 3).

FIG. 9 illustrates, as an example of the circuit elements that may be included in the backplane layer 120, one transistor TFT1 (e.g., the fifth switching transistor ST5 in FIG. 5 or 6) electrically connected to the light emitting element EL of each of the sub-pixels SPX among the circuit elements included in each of the sub-pixels SPX. In an embodiment, the transistors TFT1 of the backplane layer 120 may be thin film transistors formed by a thin film deposition process.

In an embodiment, the backplane layer 120 may include a barrier layer BR disposed on the substrate 110. The circuit elements and the lines of the backplane layer 120 may be disposed on the barrier layer BR.

The barrier layer BR may include a material suitable for protecting the transistors TFT1 and the light emitting elements EL from moisture permeating through the substrate 110, for example, such as an inorganic insulating material. In an embodiment, the barrier layer BR may include a plurality of inorganic insulating layers that are alternately stacked.

The transistors TFT1 may be disposed on the barrier layer BR. Each transistor TFT1 may include an active layer ACT1 and a gate electrode G1.

The active layer ACT1 may be disposed on the barrier layer BR. The active layer ACT1 may include a semiconductor material. For example, the active layer ACT1 may include polycrystalline silicon (e.g., a low-temperature polycrystalline silicon), amorphous silicon, or an oxide semiconductor (e.g., indium gallium zinc oxide (IGZO), indium gallium zinc tin oxide (IGZTO), or indium gallium tin oxide (IGTO)).

The active layer ACT1 may include a channel region CHA1, a source region S1, and a drain region D1. The channel region CHA1 may overlap with the gate electrode G1 in the third direction DR3. The source region S1 may be disposed on one side of the channel region CHA1, and the drain region D1 may be disposed on another side of the channel region CHA1. At least a portion of the source region S1 and the drain region D1 may not overlap with the gate electrode G1 in the third direction DR3. A conductivity (e.g., a carrier concentration) of the source region S1 and the drain region D1 may be higher than a conductivity of the channel region CHA1.

A first insulating layer INS1 may be disposed on the active layer ACT1.

A first conductive layer may be disposed on the first insulating layer INS1. The first conductive layer may include a gate electrode G1 of each transistor TFT1, and a first capacitor electrode CAE1 of each sub-pixel SPX. The gate electrode G1 of each transistor TFT1 and the active layer ACT1 may overlap with each other in the third direction DR3. For example, the gate electrode G1 of each transistor TFT1 may be disposed on the channel region CHA1 of the active layer ACT1. In an embodiment, when the gate electrode G1 of at least one transistor TFT1 is electrically connected to the first capacitor electrode CAE1 of a corresponding sub-pixel SPX, the gate electrode G1 and the first capacitor electrode CAE1 may be integrally formed with each other.

A second insulating layer INS2 may be disposed on the first conductive layer.

A second conductive layer may be disposed on the second insulating layer INS2. The second conductive layer may include a second capacitor electrode CAE2 of each sub-pixel SPX. The first capacitor electrode CAE1 and the second capacitor electrode CAE2 of each sub-pixel SPX may overlap with each other in the third direction DR3. The capacitor (e.g., the storage capacitor Cst in FIG. 5 or 6) of each sub-pixel SPX may be formed by the first capacitor electrode CAE1, the second capacitor electrode CAE2, and the second insulating layer INS2.

A third insulating layer INS3 may be disposed on the second conductive layer.

A third conductive layer may be disposed on the third insulating layer INS3. The third conductive layer may include a first connection electrode PCE1 of each sub-pixel SPX. The first connection electrode PCE1 may be electrically connected to a portion of the active layer ACT1 (e.g., the drain region D1) through a first contact hole PCT1 penetrating through the first insulating layer INS1, the second insulating layer INS2, and the third insulating layer INS3.

A fourth insulating layer INS4 may be disposed on the first connection electrode PCE1.

A fourth conductive layer may be disposed on the fourth insulating layer INS4. The fourth conductive layer may include a second connection electrode PCE2 of each sub-pixel SPX. The second connection electrode PCE2 may be connected to the first connection electrode PCE1 through a second contact hole PCT2 penetrating through the fourth insulating layer INS4.

A fifth insulating layer INS5 may be disposed on the second connection electrode PCE2. The fifth insulating layer INS5 may cover the circuit elements (e.g., the transistors TFT1) and the lines included in the backplane layer 120. The fifth insulating layer INS5 may planarize or substantially planarize step differences caused by the circuit elements and lines of the backplane layer 120.

In an embodiment, each of the barrier layer BR, the first insulating layer INS1, the second insulating layer INS2, and the third insulating layer INS3 may include at least one inorganic insulating layer including an inorganic insulating material (e.g., silicon nitride (SiNₓ), silicon oxide nitride (SiON), silicon oxide (SiOₓ), titanium oxide (TiOₓ), or aluminum oxide (AlOₓ)). Each of the barrier layer BR, the first insulating layer INS1, the second insulating layer INS2, and the third insulating layer INS3 may include a single-layer or multi-layered structure.

In an embodiment, each of the fourth insulating layer INS4 and the fifth insulating layer INS5 may include at least one organic insulating layer including an organic insulating material (e.g., an acrylic resin, an epoxy resin, a phenolic resin, a polyamide resin, or a polyimide resin). Each of the fourth insulating layer INS4 and the fifth insulating layer INS5 may include a single-layer or multi-layered structure.

Each of the first, second, third, and fourth conductive layers may include a conductive material (e.g., any one of molybdenum (Mo), aluminum (Al), chromium (Cr), gold (Au), titanium (Ti), nickel (Ni), neodymium (Nd), copper (Cu), or a suitable alloy thereof). Each of the first, second, third, and fourth conductive layers may include a single-layer or multi-layered structure.

The light emitting element layer 130 may be disposed on the fifth insulating layer INS5. The light emitting element layer 130 may include light emitting elements EL of the sub-pixels SPX, and a pixel defining layer PDL. In an embodiment, the light emitting element layer 130 may further include a spacer disposed on a portion of the pixel defining layer PDL. In an embodiment, the light emitting element layer 130 may further include a capping layer CPL covering the light emitting elements EL.

The pixel defining layer PDL may be disposed on the fifth insulating layer INS5 to define or partition the light emitting areas EA. For example, the pixel defining layer PDL may include openings corresponding to the light emitting areas EA, and may be disposed in the non-light emitting areas NEA to surround (e.g., around peripheries of) the light emitting areas EA. In an embodiment, the pixel defining layer PDL may cover edge portions of first electrodes AE of the light emitting element, and may be opened to expose other portions including the central portions of the first electrodes AE. The area where the first electrode AE of each light emitting element EL is exposed may correspond to the light emitting area EA of each pixel PX, and a light emitting layer EML of each of the light emitting elements EL may be disposed on a portion of the corresponding first electrode AE that is not covered with the pixel defining layer PDL. The pixel defining layer PDL may also be referred to as a "bank".

In an embodiment, the pixel defining layer PDL may include an inorganic insulating material. For example, the pixel defining layer PDL may include at least one organic insulating layer including an acryl resin, an epoxy resin, a phenolic resin, a polyamide resin, or a polyimide resin.

The light emitting elements EL may include a first light emitting element EL1 included in the first sub-pixel SPX1, a second light emitting element EL2 included in the second sub-pixel SPX2, and a third light emitting element EL3 included in the third sub-pixel SPX3. The first light emitting element EL1, which is a light emitting element EL of the first sub-pixel SPX1, may be disposed in the first light emitting area EA1. The second light emitting element EL2, which is a light emitting element EL of the second sub-pixel SPX2, may be disposed in the second light emitting area EA2. The third light emitting element EL3, which is a light emitting element EL of the third sub-pixel SPX3, may be disposed in the third light emitting area EA3.

Each light emitting element EL may include the first electrode AE positioned in a corresponding light emitting area EA, and a light emitting layer EML and a second electrode CE sequentially disposed on the first electrode AE. In an embodiment, each light emitting element EL may include at least one intermediate layer IML. As an example, each light emitting element EL may include an intermediate layer IML disposed between the first electrode AE and the light emitting layer EML, and an intermediate layer IML disposed between the light emitting layer EML and the second electrode CE. FIG. 9 illustrates an embodiment in which each light emitting element EL includes a single light emitting layer EML, but the present invention is not limited thereto. For example, the light emitting element EL may have a tandem structure including a plurality of light emitting layers EML overlapping with each other.

The first electrode AE of the light emitting element EL may be disposed on the fifth insulating layer INS5. The first electrode AE of the light emitting element EL may be electrically connected to the transistor TFT1 included in the corresponding sub-pixel SPX. For example, the first electrode AE of the first light emitting element EL1 may be electrically connected to the transistor TFT1 included in the first sub-pixel SPX1 through a first connection hole CT1 or the like. The first electrode AE of the second light emitting element EL2 may be electrically connected to the transistor TFT1 included in the second sub-pixel SPX2 through a second connection hole CT2 or the like. The first electrode AE of the third light emitting element EL3 may be electrically connected to the transistor TFT1 included in the third sub-pixel SPX3 through a third connection hole CT3 or the like. As an example, the first electrode AE of the first light emitting element EL1 may be electrically connected to the transistor TFT1 of the first sub-pixel SPX1 through the first and second connection electrodes PCE1 and PCE2 of the first sub-pixel SPX1 and the first connection hole CT1. The first electrode AE of the second light emitting element EL2 may be electrically connected to the transistor TFT1 of the second sub-pixel SPX2 through the first and second connection electrodes PCE1 and PCE2 of the second sub-pixel SPX2 and the second connection hole CT2. The first electrode AE of the third light emitting element EL3 may be electrically connected to the transistor TFT1 of the third sub-pixel SPX3 through the first and second connection electrodes PCE1 and PCE2 of the third sub-pixel SPX3 and the third connection hole CT3.

Each of the connection holes CT may electrically connect the light emitting element EL and the pixel circuit PXC of a corresponding sub-pixel SPX to each other, and may be formed to penetrate through an insulating layer disposed between the light emitting element EL and the circuit elements of the pixel circuit PXC, including the transistor TFT. For example, the connection holes CT may be contact holes or via holes that penetrate through the fifth insulating layer INS5 disposed on the transistors TFT of the backplane layer 120 and disposed below (e.g., under) the light emitting elements EL.

The first electrode AE included in the light emitting element EL of each sub-pixel SPX may fill the connection hole CT of each sub-pixel SPX, and may be electrically connected to the transistor TFT1 of each sub-pixel SPX through the connection hole CT. The connection holes CT and a portion of the first electrodes AE filling the connection holes CT may be disposed in the non-light emitting area NEA, and may be covered with the pixel defining layer PDL. Accordingly, no bending or step difference may occur in the light emitting areas EA due to the connection holes CT. For example, different portions of the first electrodes AE positioned in each of the light emitting areas EA may be flat or substantially flat.

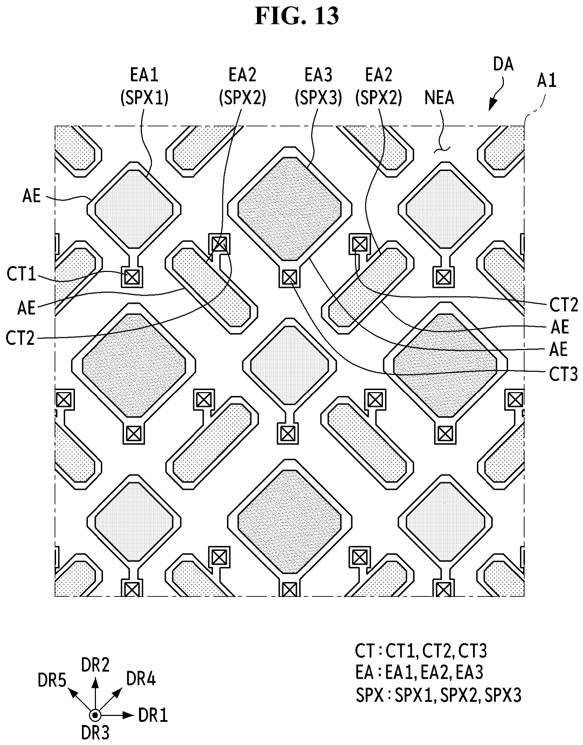

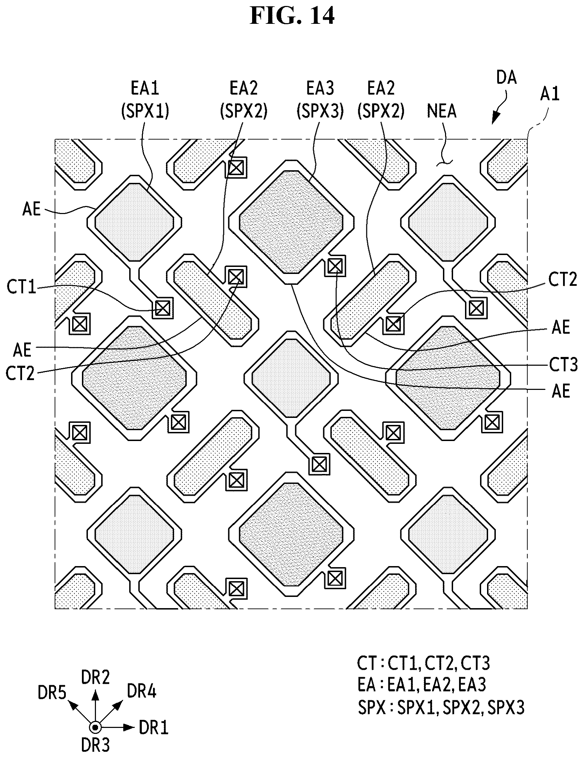

FIG. 9 illustrates that the connection holes CT are disposed at arbitrary positions within the non-light emitting area NEA, but the positions of the connection holes CT may be variously adjusted or optimized depending on the arrangement structure of the light emitting areas EA. Examples of the arrangement structures of the connection holes CT will be described in more detail below with reference to FIGS. 13 and 14.

The first electrode AE of the light emitting element EL may have a size and a shape corresponding to each light emitting area EA, and most of the first electrode AE may be disposed in the light emitting area EA. An edge portion of the first electrode AE of the light emitting element EL may be disposed in the non-light emitting area NEA around the light emitting area EA, and may be covered with the pixel defining layer PDL.

The first electrode AE of the light emitting element EL may be a single-layer or multi-layered electrode including at least one conductive material. In an embodiment, the display panel 100 may be a front-emitting display panel, and the first electrode AE may include a reflective electrode layer including a suitable material (e.g., a metal) having a high reflectivity.

The light emitting layer EML of the light emitting element EL may include a polymer or small molecule material that emits light of a desired color (e.g., red, green, or blue). In an embodiment, the light emitting elements EL of the first sub-pixel SPX1, the second sub-pixel SPX2, and the third sub-pixel SPX3 may each include a light emitting layer EML that is individually disposed in the light emitting areas EA, and may emit light of different colors from each other. For example, the light emitting layer EML of the first light emitting element EL1, the light emitting layer EML of the second light emitting element EL2, and the light emitting layer EML of the third light emitting element EL3 may be individually disposed in the first light emitting area EA1, the second light emitting area EA2, and the third light emitting area EA3, respectively, and may emit light of a first color (e.g., red light), light of a second color (e.g., green light), and light of a third color (e.g., blue light), respectively. In an embodiment, the light emitting layer EML of each of the light emitting elements EL may be an organic light emitting layer including an organic material.

The intermediate layers IML may be disposed between the first electrode AE and the second electrode CE of each of the light emitting elements EL, and may overlap with the light emitting layer EML of each of the light emitting elements EL. Each intermediate layer IML may include at least one of a hole injection layer, a hole transport layer, a charge generation layer, an electron transport layer, and/or an electron injection layer. In addition, each intermediate layer IML may be formed as a single layer or multi-layers

For example, the intermediate layer IML disposed between the first electrode AE and the light emitting layer EML of each of the light emitting elements EL may include a hole injection layer and a hole transport layer sequentially stacked on the first electrode AE. The intermediate layer IML disposed between the light emitting layer EML and the second electrode CE of each of the light emitting elements EL may include an electron transport layer.

In an embodiment, the intermediate layers IML may be formed as a common layer that is entirely disposed in the display area DA. In each light emitting area EA, the intermediate layers IML may be disposed between the first electrode AE and the second electrode CE of each of the light emitting elements EL. In the non-light emitting area NEA, the intermediate layers IML may be sequentially stacked on the pixel defining layer PDL (or the pixel defining layer PDL and the spacer), and covered with the capping layer CPL and the second electrode CE of the light emitting elements EL.

The second electrode CE of the light emitting element EL may include a conductive material. In an embodiment, the second electrode CE may be formed as a common layer that is entirely disposed in the display area DA. For example, the second electrode CE may be entirely disposed in the display area DA including the light emitting areas EA and the non-light emitting area NEA. In an embodiment, the display panel 100 may be a front-emitting display panel, and the second electrode CE may include a transparent or semi-transparent electrode layer.

In an embodiment, the capping layer CPL may be disposed on the light emitting elements EL. The capping layer CPL may be entirely disposed in the display area DA to entirely cover the light emitting elements EL. The capping layer CPL may include a material suitable for protecting the light emitting elements EL, for example, such as an inorganic insulating material, and may be optically transparent so that light generated from the light emitting elements EL may be transmitted. In an embodiment, the capping layer CPL may include a plurality of inorganic insulating layers alternately stacked. In an embodiment, a refractive index of the inorganic insulating layers included in the capping layer CPL may be adjusted so that the light generated from the light emitting elements EL may be more effectively emitted. The capping layer CPL may be omitted as needed or desired.

The encapsulation layer 140 may be disposed on the light emitting element layer 130. The encapsulation layer 140 may cover the light emitting element layer 130 in the display area DA, and may extend to the non-display area NDA to be in contact with the backplane layer 120. For example, the encapsulation layer 140 may be disposed in the display area DA to cover the light emitting element layer 130, and an end portion of the encapsulation layer 140 may be positioned at a portion of the non-display area NDA adjacent to the display area DA. The encapsulation layer 140 may block the permeation of oxygen or moisture into the light emitting element layer 130, and may alleviate electrical and/or physical shock to the backplane layer 120 and the light emitting element layer 130.

In an embodiment, the encapsulation layer 140 may be formed as multi-layers including an inorganic encapsulation layer and an organic encapsulation layer. As an example, the encapsulation layer 140 may include a first inorganic encapsulation layer ENL1, an organic encapsulation layer ENL2, and a second inorganic encapsulation layer ENL3 sequentially stacked on the light emitting element layer 130. The encapsulation layer 140 may be replaced with an encapsulation member of a different kind, structure, and/or material. For example, the light emitting element layer 130 may be encapsulated using an upper substrate including an insulating material such as glass, or a protective layer including a capping layer of a single layer or multi-layers.

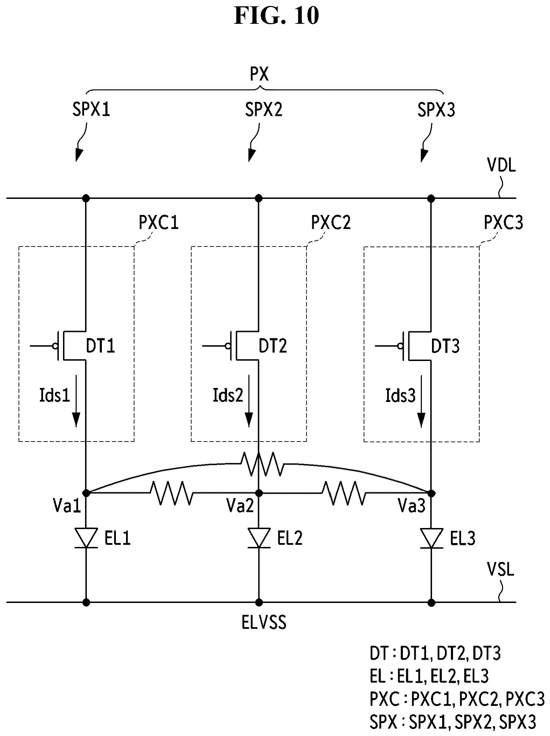

FIG. 10 is an equivalent circuit diagram illustrating an operation during a light emitting period of a pixel according to an embodiment. For example, FIG. 10 schematically illustrates an equivalent circuit diagram during the light emitting period of one first sub-pixel SPX1, one second sub-pixel SPX2, and one third sub-pixel SPX3 that may be included in a pixel PX according to an embodiment. The pixel PX may include only three sub-pixels SPX as illustrated in FIG. 10, or may further include one or more other sub-pixels SPX.

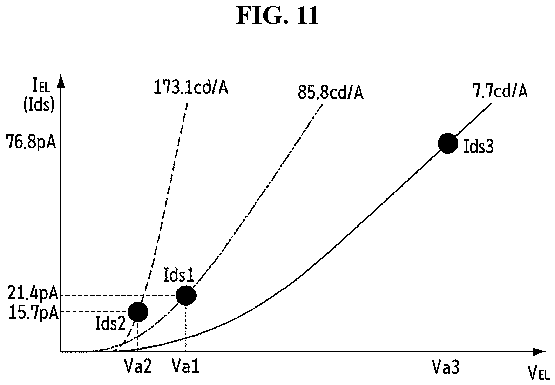

FIG. 11 is a graph illustrating voltage-current characteristics of light emitting elements included in sub-pixels according to an embodiment. For example, FIG. 11 illustrates the voltage-current characteristics of the first light emitting element EL1, the second light emitting element EL2, and the third light emitting element EL3 illustrated in FIGS. 9 and 10. In FIG. 11, a dotted line corresponding to a first driving current Ids1 illustrates the voltage-current characteristic of the first light emitting element EL1, another dotted line corresponding to a second driving current Ids2 illustrates the voltage-current characteristic of the second light emitting element EL2, and a solid line corresponding to a third driving current Ids3 illustrates the voltage-current characteristics of the third light emitting element EL3.

Referring to FIGS. 10 and 11 in addition to FIGS. 1 to 9, each sub-pixel SPX may include a pixel circuit PXC and a light emitting element EL. For example, the first sub-pixel SPX1 may include a first pixel circuit PXC1 including a first driving transistor DT1, and a first light emitting element EL1 electrically connected to the first pixel circuit PXC1. The second sub-pixel SPX2 may include a second pixel circuit PXC2 including a second driving transistor DT2, and a second light emitting element EL2 electrically connected to the second pixel circuit PXC2. The third sub-pixel SPX3 may include a third pixel circuit PXC3 including a third driving transistor DT3, and a third light emitting element EL3 electrically connected to the third pixel circuit PXC3. Each of the first pixel circuit PXC1, the second pixel circuit PXC2, and the third pixel circuit PXC3 may further include additional circuit elements (e.g., the switching transistors ST and the storage capacitor Cst in FIG. 5 or 6), in addition to the driving transistor DT.

During the light emitting period of the pixel PX, a driving current Ids having a magnitude controlled by each driving transistor DT may flow through each sub-pixel SPX. For example, during the light emitting period of the pixel PX, the first driving transistor DT1 may supply a first driving current Ids1 corresponding to a gate voltage (e.g., a voltage of the first node N1 in FIG. 5 or 6) applied to a gate electrode of the first driving transistor DT1 to the first light emitting element EL1, the second driving transistor DT2 may supply a second driving current Ids2 corresponding to a gate voltage applied to a gate electrode of the second driving transistor DT2 to the second light emitting element EL2, and the third driving transistor DT3 may supply a third driving current Ids3 corresponding to a gate voltage applied to a gate electrode of the third driving transistor DT3 to the third light emitting element EL3. Accordingly, the first light emitting element EL1, the second light emitting element EL2, and the third light emitting element EL3 may emit light having a luminance corresponding to the first driving current Ids1, the second driving current Ids2, and the third driving current Ids3, respectively. In addition, a first voltage Va1, a second voltage Va2, and a third voltage Va3 may be applied to the first electrode AE of the first light emitting element EL1, the first electrode AE of the second light emitting element EL2, and the first electrode AE of the third light emitting element EL3, respectively.

In some embodiments, the first light emitting element EL1, the second light emitting element EL2, and the third light emitting element EL3 may emit light of different colors from each other, and light emitting efficiencies of the first light emitting element EL1, the second light emitting element EL2, and the third light emitting element EL3 may be different from each other. For example, the first light emitting element EL1, the second light emitting element EL2, and the third light emitting element EL3 may be a red organic light emitting diode, a green organic light emitting diode, and a blue organic light emitting diode, respectively. In addition, among the light emitting efficiencies of the first light emitting element EL1, the second light emitting element EL2, and the third light emitting element EL3, the light emitting efficiency of the second light emitting element EL2 may be the highest, and the light emitting efficiency of the third light emitting element EL3 may be the lowest. For example, when the pixel PX expresses a standard white color of 11 gradations (e.g., a gray corresponding to a brightness of 11 gradations), the first light emitting element EL1, the second light emitting element EL2, and the third light emitting element EL3 may exhibit the light emitting efficiencies of 85.8 cd/A, 173.1 cd/A, and 7.7 cd/A, respectively.

Accordingly, a slope of a voltage-current curve of the second light emitting element EL2 may be greater than a slope of a voltage-current curve of the first light emitting element EL1 and a slope of a voltage-current curve of the third light emitting element EL3. In the graph of FIG. 11, the horizontal axis represents a voltage V_{EL} applied to each light emitting element EL (e.g., an anode voltage applied to the first electrode AE of each light emitting element EL), and the vertical axis represents a current I_{EL} flowing through each light emitting element EL. The current I_{EL} flowing through each light emitting element EL may correspond to the driving current Ids supplied to the light emitting element EL by the driving transistor DT.

For example, when the pixel PX expresses a standard white color of 11 gradations, the first driving current Ids1 of approximately 21.4 pA may flow through the first light emitting element EL1, the second driving current Ids2 of approximately 15.7 pA may flow through the second light emitting element EL2, and the third driving current Ids3 of approximately 76.8 pA may flow through the third light emitting element EL3. Even when the pixel PX expresses a standard white color of different gradations, a driving current Ids greater than the driving current Ids flowing through each of the first light emitting element EL1 and the second light emitting element EL2 flows through the third light emitting element EL3, and a driving current Ids smaller than the driving current Ids flowing through each of the first light emitting element EL1 and the third light emitting element EL3 may flow through the second light emitting element EL2.

During the light emitting period in which the pixel PX expresses the standard white color of 11 gradations, the first voltage Va1 may be applied to the first electrode AE of the first light emitting element EL1, the second voltage Va2 lower than the first voltage Va1 may be applied to the first electrode AE of the second light emitting element EL2, and the third voltage Va3 greater than the first voltage Va1 may be applied to the first electrode AE of the third light emitting element EL3. Even when the pixel PX expresses the standard white color of different gradations, a voltage greater than the voltage applied to each of the first electrodes AE of the first light emitting element EL1 and the second light emitting element EL2 may be applied to the first electrode AE of the third light emitting element EL3, and a voltage lower than the voltage applied to each of the first electrodes AE of the first light emitting element EL1 and the third light emitting element EL3 may be applied to the first electrode AE of the second light emitting element EL2.

However, because the second light emitting element EL2 has a higher light emitting efficiency, it may emit light having a higher luminance even with a low second driving current Ids2. On the other hand, because the third light emitting element EL3 has a lower light emitting efficiency, it may emit light having a lower luminance even for a high third driving current Ids3. For example, during the light emitting period in which the pixel PX expresses the standard white color of 11 gradations, the second light emitting element EL2 may emit light having a higher luminance than those of the first light emitting element EL1 and the third light emitting element EL3, and the third light emitting element EL3 may emit light having a lower luminance than those of the first light emitting element EL1 and the second light emitting element EL2. Even when the pixel PX expresses the standard white color of different gradations, the second light emitting element EL2 may emit light having a higher luminance than those of the first light emitting element EL1 and the third light emitting element EL3, and the third light emitting element EL3 may emit light having a lower luminance than those of the first light emitting element EL1 and the second light emitting element EL2.

When the pixel PX expresses a standard white color (e.g., an achromatic color of a specific luminance) corresponding to a specific gradation, the relative brightness of the first sub-pixel SPX1, the second sub-pixel SPX2, and the third sub-pixel SPX3 may be adjusted and/or differentiated in consideration of a human's perception characteristics. For example, when the pixel PX expresses the standard white color, the driving current Ids flowing through each of the sub-pixels SPX may be controlled so that a luminance proportion of the second sub-pixel SPX2 that emits the green light is the largest, and a luminance proportion of the third sub-pixel SPX3 that emits the blue light is the smallest. Accordingly, during the light emitting period in which the pixel PX including the first light emitting element EL1, the second light emitting element EL2, and the third light emitting element EL3 expresses the standard white color, the first light emitting element EL1, the second light emitting element EL2, and the third light emitting element EL3 of the pixel PX may emit light with a different luminance from each other. For example, during a light emitting period in which the pixel PX expresses a standard white color of a specific gradation, the second light emitting element EL2 among the first light emitting element EL1, the second light emitting element EL2, and the third light emitting element EL3 of the pixel PX may emit light having the highest luminance, and the third light emitting element EL3 may emit light having the lowest luminance. As an example, during a light emitting period in which the pixel PX expresses white of the highest gradation, the luminance ratio of the first sub-pixel SPX1, the second sub-pixel SPX2, and the third sub-pixel SPX3 may be controlled to approximately 22:71:7 or 21:72:7.

The sub-pixels SPX may be supplied with a data voltage Vdata that is adjusted and/or differentiated according to the characteristics of each light emitting element EL, and may be driven by a driving current Ids corresponding to each data voltage Vdata. For example, the display driver 200 of FIGS. 2 to 4 may output each data voltage Vdata adjusted according to the characteristics of each sub-pixel SPX, so that an optimal driving current Ids may flow through each sub-pixel SPX.

As described above, the light emitting elements EL of the sub-pixels SPX that emit light of different colors from each other may be driven with different driving currents Ids from each other. For example, during a light emitting period in which the first light emitting element EL1, the second light emitting element EL2, and the third light emitting element EL3 of the pixel PX all emit light to express a standard white color, the driving currents Ids having different magnitudes from each other may flow through the first light emitting element EL1, the second light emitting element EL2, and the third light emitting element EL3 of the pixel PX. Accordingly, different voltages may be applied to the first electrodes AE of the first light emitting element EL1, the second light emitting element EL2, and the third light emitting element EL3 of the pixel PX. For example, during the light emitting period in which the pixel PX expresses the standard white color, a voltage greater than the voltage applied to each of the first electrodes AE of the first light emitting element EL1 and the second light emitting element EL2 of the pixel PX may be applied to the first electrode AE of the third light emitting element EL3 of the pixel PX. In addition, during the light emitting period in which the pixel PX expresses the standard white color, a difference between the voltages applied to the first electrodes AE of the second light emitting element EL2 and the third light emitting element EL3 of the pixel PX may be the largest. For example, during the light emitting period in which the pixel PX expresses the standard white color, a difference between the voltage applied to the first electrode AE of the second light emitting element EL2 of the pixel PX and the voltage applied to the first electrode AE of the third light emitting element EL3 of the pixel PX may be greater than a difference between the voltage applied to the first electrode AE of the first light emitting element EL1 of the pixel PX and the voltage applied to the first electrode AE of the second light emitting element EL2 of the pixel PX.

The light emitting elements EL of the sub-pixels SPX may not be completely physically and/or electrically separated from each other. As an example, the light emitting elements EL may share the common layer IML and the second electrode CE, and there may be a resistance component between the first electrodes AE of the sub-pixels SPX.

As the difference in the voltages applied to the light emitting elements EL of the sub-pixels SPX that are adjacent to each other increases, a risk of a leakage current occurring between the sub-pixels SPX may increase. For example, between the second sub-pixel SPX2 and third sub-pixel SPX3 that are adjacent to each other, a lateral leakage current may flow from the third light emitting element EL3 to the second light emitting element EL2.

However, in some embodiments, the leakage current flowing from the third light emitting element EL3 to the second light emitting element EL2 may be effectively reduced or prevented by increasing a spacing between the second light emitting area EA2 and the third light emitting area EA3 that are adjacent to each other as described above. Accordingly, even when a fine driving current Ids flows through the sub-pixels SPX of the pixel PX in response to a low-gradation image data, the lateral leakage current between the sub-pixels SPX may be effectively reduced or prevented.

Additionally, in some embodiments, the spacing between the first light emitting area EA1 and the second light emitting area EA2 may be smaller than the spacing between the second light emitting area EA2 and the third light emitting area EA3. However, because a difference in a driving voltage between the first light emitting element EL1 and the second light emitting element EL2 is smaller, substantially no leakage current may occur between the first sub-pixel SPX1 and the second sub-pixel SPX2. For example, because a difference between the first voltage Va1 applied to the first electrode AE of the first light emitting element EL1 and the second voltage Va2 applied to the first electrode AE of the second light emitting element EL2 is minimal, no lateral leakage current may occur, or only a very small lateral leakage current may occur between the first sub-pixel SPX1 and the second sub-pixel SPX2.

Therefore, according to some embodiments, by adjusting and/or differentiating the spacing between the light emitting areas EA of the sub-pixels SPX according to the difference in the driving currents Ids (e.g., the first driving current Ids1, the second driving current Ids2, and the third driving current Ids3) of the sub-pixels SPX and the driving voltages (e.g., the first voltage Va1, the second voltage Va2, and the third voltage Va3) of the sub-pixels SPX, the lateral leakage current between the sub-pixels SPX may be effectively reduced, while securing the aperture ratio of the display device 1.

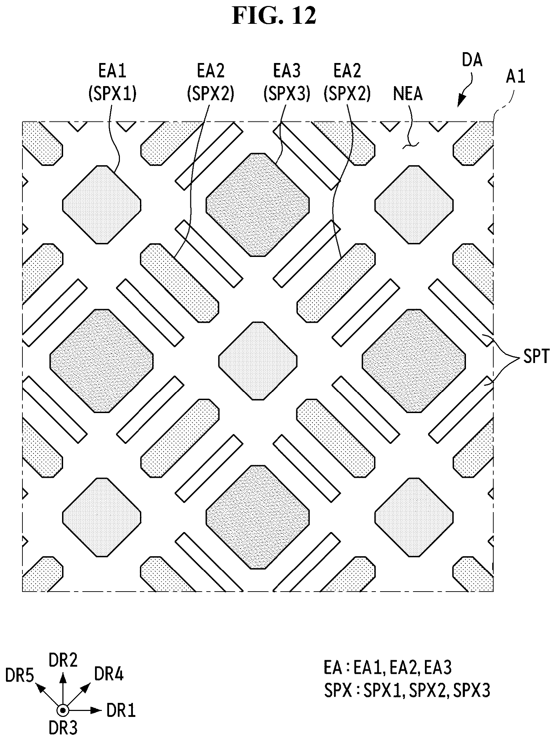

FIG. 12 is a plan view illustrating a display area of a display panel according to an embodiment. For example, FIG. 12 illustrates an example of a portion of the display area DA corresponding to the area A1 in FIG. 3. Hereinafter with reference to FIG. 12, redundant description of portions that are the same or substantially the same as (or similar to) those of at least one embodiment described above (e.g., the embodiment in FIG. 7) may not be repeated.

Referring to FIG. 12 in addition to FIGS. 1 to 11, the display panel 100 according to an embodiment may further include separation structures SPT disposed in the non-light emitting area NEA.

The separation structures SPT may have a shape suitable for reducing or blocking a leakage current through the common layer IML and/or the like, and may be disposed in a portion of the non-light emitting area NEA. For example, the separation structures SPT may be formed in a suitable shape that may cause bending or a disconnection of the common layer IML and/or the like by being disposed on a surface of a portion of the pixel defining layer PDL, or on an upper portion of a portion of the pixel defining layer PDL.

In an embodiment, each of the separation structures SPT may be formed as a dug groove in the surface of the pixel defining layer PDL. When each of the separation structures SPT is formed as a groove in the pixel defining layer PDL, at least one groove may be formed in the pixel defining layer PDL at a position where each separation structure SPT is disposed. Accordingly, a bending may be formed on the surface of the pixel defining layer PDL at the position where each separation structure SPT is disposed.

In another embodiment, each of the separation structures SPT may be formed as an island-shaped pattern disposed on the pixel defining layer PDL. When each of the separation structures SPT is formed as an island-shaped pattern, a single separation structure SPT or a separation structure SPT including at least two split patterns may be disposed on the pixel defining layer PDL at the position where each separation structure SPT is disposed. Each separation structure SPT may be formed as a column spacer including an insulating material (e.g., an organic insulating material), but the present invention is not limited thereto. Accordingly, a bending may be formed on the pixel defining layer PDL at the position where each separation structure SPT is disposed.

In another embodiment, the display panel 100 may also include heterogeneous separation structures SPT. For example, some of the separation structures SPT may be formed as dug grooves on the surface of the pixel defining layer PDL, and others of the separation structures SPT may be formed as an island-shaped pattern.

In an embodiment, each separation structure SPT may be disposed between a corresponding second light emitting area EA2 and a corresponding third light emitting area EA3 that are adjacent to each other. For example, each separation structure SPT may be disposed in a portion of the non-light emitting area NEA having a relatively wider width as the spacing between the second light emitting area EA2 and the third light emitting area EA3 increases.

Accordingly, it may be possible to more effectively reduce or minimize the leakage current that may flow between the second sub-pixel SPX2 and the third sub-pixel SPX3. In addition, each separation structure SPT may be more easily and/or stably formed by securing a sufficient area in which each separation structure SPT may be formed.

In an embodiment, the separation structures SPT may extend in a direction in which each of the second light emitting areas EA2 extends, and may be disposed parallel to or substantially parallel to the second light emitting areas EA2. For example, the separation structures SPT may be positioned on respective sides of each of the second light emitting areas EA2, and may be disposed parallel to or substantially parallel to the long sides of each of the second light emitting areas EA2. Accordingly, a leakage current flowing into the second light emitting areas EA2 may be more effectively reduced or prevented.

FIG. 13 is a plan view illustrating positions of a light emitting area and connection holes in a non-light emitting area of a display panel according to an embodiment. FIG. 14 is a plan view illustrating positions of a light emitting area and connection holes in a non-light emitting area of a display panel according to an embodiment. For example, FIGS. 13 and 14 illustrate different embodiments of a portion of the display area DA corresponding to the area A1 of FIG. 3. Compared with the embodiment illustrated in FIG. 7, FIGS. 13 and 14 further illustrate the first electrode AE included in the light emitting element EL of each of the sub-pixels SPX, and the connection hole CT for electrically connecting the light emitting element EL and the circuit element (e.g., the transistor TFT1 in FIG. 9) to each other of each of the sub-pixels SPX.

Referring to FIGS. 13 and 14 in addition to FIGS. 1 to 12, the connection holes CT of the sub-pixels SPX may be positioned in a portion of the non-light emitting area NEA adjacent to the light emitting area EA of each of the sub-pixels SPX, and may be covered with the pixel defining layer PDL. In some embodiments, the first light emitting area EA1 and the second light emitting area EA2 may be positioned relatively closer to each other, and thus, the non-light emitting area NEA between the first light emitting area EA1 and the second light emitting area EA2 may have a narrower width.

The connection holes CT of the sub-pixels SPX according to some embodiments may be disposed in another peripheral area, avoiding a narrower area between the first light emitting area EA1 and the second light emitting area EA2. For example, each of the connection holes CT of the sub-pixels SPX may be disposed between a corresponding first light emitting area EA1 and a corresponding third light emitting area EA3 that are adjacent to each other, or between a corresponding second light emitting area EA2 and a corresponding third light emitting area EA3 that are adjacent to each other. In some embodiments, the display panel 100 includes the separation structures SPT, as described above with reference to the embodiment illustrated in FIG. 12, and at least some of the connection holes CT of the sub-pixels SPX may overlap with the separation structures SPT.

In an embodiment, as illustrated in FIG. 13, first connection holes CT1 of the first sub-pixels SPX1 and second connection holes CT2 of the second sub-pixels SPX2 may be disposed in a direction toward the third light emitting areas EA3. For example, each of the first connection holes CT1 of the first sub-pixels SPX1 may be disposed between a corresponding pair of a first light emitting area EA1 and a third light emitting area EA3 that are adjacent to each other, and each of the second connection holes CT2 of the second sub-pixels SPX2 may be disposed between a corresponding pair of a second light emitting area EA2 and a third light emitting area EA3 that are adjacent to each other. Each of third connection holes CT3 of the third sub-pixels SPX3 may be disposed between a corresponding pair of a first light emitting area EA1 and a third light emitting area EA3 that are adjacent to each other, but the present invention is not limited thereto.

In another embodiment, as illustrated in FIG. 14, the connection holes CT of the sub-pixels SPX may be disposed between the second light emitting areas EA2 and the third light emitting areas EA3. For example, each of the first connection holes CT1 of the first sub-pixels SPX1, the second connection holes CT2 of the second sub-pixels SPX2, and the third connection holes CT3 of the third sub-pixels SPX3 may be disposed between a corresponding pair of a second light emitting area EA2 and a third light emitting area EA3 that are adjacent to each other. In an embodiment, only one connection hole CT may be disposed between a pair of a second light emitting area EA2 and a third light emitting area EA3 that are adjacent to each other in the fourth direction DR4 or the fifth direction DR5.

According to some embodiments described above, the connection holes CT of the sub-pixels SPX may be appropriately distributed and disposed in a portion of the non-light emitting area NEA having a relatively larger width, avoiding the narrower area between the first light emitting area EA1 and the second light emitting area EA2. Accordingly, the design structure of the display device 1 may be improved or optimized, and the connection holes CT of the sub-pixels SPX may be more easily and/or stably formed.

Additionally, as the connection holes CT of the sub-pixels SPX are mainly disposed around the third light emitting areas EA3, a leakage current between the sub-pixels SPX may be more effectively reduced. For example, when the connection holes CT of the sub-pixels SPX are disposed between the second light emitting areas EA2 and the third light emitting areas EA3 as in the embodiment illustrated in FIG. 14, a bending may occur in the pixel defining layer PDL at a portion covering the connection holes CT of the sub-pixels SPX, thereby further reducing the lateral leakage current between the second sub-pixels SPX2 and the third sub-pixels SPX3.

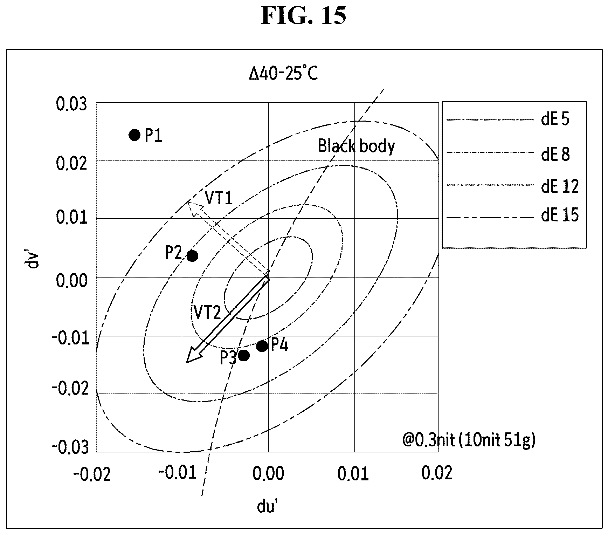

FIG. 15 is a graph illustrating a color change of some sample display devices according to a temperature change. For example, FIG. 15 is a temperature color shift (TCS) chromaticity diagram illustrating values obtained by measuring a color coordinate change (du', dv') of the sub-pixels SPX according to a temperature change from 25°C to 40°C in four kinds of sample display devices P1, P2, P3, and P4, and illustrates a color shift according to the temperature change of the sample display devices P1, P2, P3, and P4 as a du' vs. dv' graph.

Referring to FIG. 15 in addition to FIGS. 1 to 14, when the temperature of the sample display devices P1, P2, P3, and P4 changes, an amount of change in a luminance of the sub-pixels SPX forming the pixel PX may be different. Accordingly, the temperature changes of the sample display devices P1, P2, P3, and P4 may cause color changes of images displayed on the sample display devices P1, P2, P3, and P4.

FIG. 15 illustrates results of measuring the color coordinate change (du', dv') of the sample display devices P1, P2, P3, and P4 under specific luminance conditions. For example, FIG. 15 illustrates the color coordinate change (du', dv') according to the temperature change of the sample display devices P1, P2, P3, and P4 (e.g., the color coordinate change (du', dv') of the same gradation corresponding to high temperature of 40°C compared to the color coordinate of 0.3 nit standard white corresponding to 10 nit 51g at room temperature of 25°C), when the sample display devices P1, P2, P3, and P4 express a standard white of a low gradation corresponding to a low luminance of 0.3 nit.

In FIG. 15, trajectories of each dotted line corresponding to dE5, dE8, dE12, and dE15 are trajectories connecting points with color difference ΔE (delta E) values of 5, 8, 12, and 15, respectively, and may be used as indicators for determining the color changes in the sample display devices P1, P2, P3, and P4. A smaller color difference value means a smaller color coordinate change (du', dv') depending on temperature, and may be seen as having excellent temperature characteristics (e.g., TCS characteristics).

In addition, a color tone may change depending on a direction of movement of the color coordinates (u', v'). For example, in the graph of FIG. 15, when the color coordinates (u', v') move to a first quadrant, the color tone may become redder or yellower, and when the color coordinates (u', v') move to a second quadrant, the color tone may become yellower or greener. In addition, when the color coordinates (u', v') move to a third quadrant, the color tone may become greener or bluer, and when the color coordinates (u', v') move to a fourth quadrant, the color tone may become bluer or purpler. For example, when the color coordinates (u', v') move in a direction of a first color shift vector VT1 illustrated by a dotted arrow in FIG. 15, the color tone becomes greener, and when the color coordinates (u', v') move in a direction of a second color shift vector VT2 illustrated by a solid arrow in FIG. 15, the color tone may become bluer.

The sample display devices P1, P2, P3, and P4 are devices with different spacing and/or apertures ratio between the sub-pixels SPX from each other, and the degree or direction of color change of the sample display devices P1, P2, P3, and P4 according to the temperature change was measured to be different from each other. For example, a first sample display device P1 was measured to exhibit a color difference significantly outside the dE15 range with a temperature change from 25°C to 40°C, whereas a second sample display device P2, a third sample display device P3, and a fourth sample display device P4 were measured to exhibit relatively smaller color differences within the dE12 range even with the temperature change from 25°C to 40°C.

As a result of checking the spacing between the light emitting areas EA of the sample display devices P1, P2, P3, and P4, it was confirmed that the spacing between the light emitting areas EA of each of the sample display devices P1, P2, P3, and P4 was uniform, but the spacing between the light emitting areas EA of the first sample display device P1 having the largest color difference according to temperature (e.g., the spacing between the light emitting areas EA of the sub-pixels SPX partitioned by the pixel defining layer PDL) was the smallest, and the spacing between the light emitting areas EA of the fourth sample display device P4 having the smallest color difference according to temperature was the largest. Accordingly, it may be estimated that the spacing between the light emitting areas EA may act as a factor affecting the temperature characteristics of the sample display devices P1, P2, P3, and P4.

The direction of movement of the color coordinates (u', v') may also affect visibility. For example, even if the amount of movement of the color coordinates (u', v') is the same, the change in color difference and luminance may differ depending on the direction of movement of the color coordinates (u', v').

When describing using the first color shift vector VT1 and the second color shift vector VT2, even if the sizes of the first color shift vector VT1 and the second color shift vector VT2 are the same, the color difference according to the first color shift vector VT1 may be greater than the color difference according to the second color shift vector VT2. For example, the color difference due to a shift of the color coordinates (u', v') by approximately 0.02 in the direction that becomes greener, such as the first color shift vector VT1, may correspond to dE 15, whereas the color difference due to a shift of approximately 0.02 in the direction that becomes bluer, such as the second color shift vector VT2, may correspond to dE 10. When the direction of movement of the color coordinates (u', v') according to the temperature change is a direction of a black body, visibility may decrease.

In addition, because the luminance ratio of the third sub-pixel SPX3 is the lowest when the pixel PX expresses standard white, a change in the color coordinates (u', v') in the direction that becomes bluer may cause a relatively lower change in luminance. Accordingly, the change in the color coordinates (u', v') in the direction that becomes bluer may be relatively more desirable for improving the temperature luminance stability (TLS) characteristics.

According to some embodiments described above, as the spacing between the second light emitting area EA2 and the third light emitting area EA3 increases, the lateral leakage current from the third sub-pixel SPX3 to the second sub-pixel SPX2 may be reduced or prevented. Accordingly, the third driving current Ids3 for causing the third light emitting element EL3 to emit light at a target luminance may be adjusted in a decreasing manner, and the second driving current Ids2 for causing the second light emitting element EL2 to emit light at a target luminance may be adjusted in an increasing manner. When the pixel PX expresses the standard white color, the second driving current Ids2 flowing through the second sub-pixel SPX2 may be smaller than the first driving current Ids1 flowing through the first sub-pixel SPX1 and the third driving current Ids3 flowing through the third sub-pixel SPX3, and accordingly, the second driving transistor DT2 may be more sensitive to temperature than the first driving transistor DT1 and the third driving transistor DT3. For example, the second driving transistor DT2 may exhibit a larger characteristic change compared to the first driving transistor DT1 and the third driving transistor DT3 depending on temperature. However, when the leakage current flowing into the second sub-pixel SPX2 is reduced by increasing the spacing between the second light emitting area EA2 and the third light emitting area EA3 as in some embodiments, the second sub-pixel SPX2 may be driven so that a larger second driving current Ids2 flows to the second driving transistor DT2. Accordingly, it may be possible to suppress the color coordinates (u', v') from moving in the direction that becomes greener by reducing the characteristic dispersion or change of the second driving transistor DT2 according to temperature.

Because a relatively larger third driving current Ids3 flows through the third driving transistor DT3, the third driving transistor DT3 may exhibit characteristics that are insensitive to temperature, and may maintain relatively uniform characteristics even when the temperature changes. In addition, even if a change in the characteristics of the third driving transistor DT3 and/or the third light emitting element EL3 occurs due to temperature, a change in the color coordinates (u', v') in the blue direction may not significantly deteriorate the temperature characteristics (e.g., TLS characteristics) of the display device 1. For example, because the luminance ratio of the third sub-pixel SPX3 is very low when the pixel PX expresses the standard white color, moving the color coordinate (u', v') in the blue direction may be more desirable for securing the TLS characteristics of the display device 1 than moving the color coordinate (u', v') in the green direction. In addition, the color difference due to the change in color coordinates (u', v') in the blue direction may be relatively smaller.

Therefore, according to some embodiments, the leakage current between the sub-pixels SPX (e.g., the lateral leakage current between the second sub-pixel SPX2 and the third sub-pixel SPX3) may be effectively reduced or prevented, and the temperature characteristics of the display device 1 (e.g., luminance and color stability of the display device 1 according to the temperature change) may be improved.

The display device 1 (or the display module 11) according to at least one of the embodiments described above may be applied to various suitable electronic devices. An electronic device according to an embodiment may include the display device 1 or the display module 11 as described above, and may further include a module or a device having additional functions in addition to the display device 1 or the display module 11.

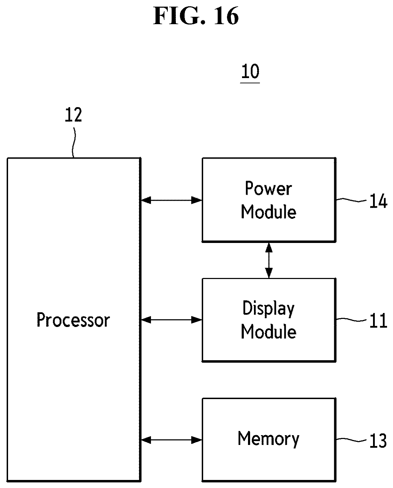

FIG. 16 is a block diagram of an electronic device according to an embodiment.

Referring to FIGS. 1 to 16, an electronic device 10 according to an embodiment may include a display module (e.g., a display or a touch-display) 11, a processor 12, a memory 13, and a power module (e.g., a power supply) 14.

The electronic device 10 may output various information in the form of an image through the display module 11. For example, when the processor 12 executes an application stored in the memory 13, image information provided by the application may be provided to the user through the display module 11.

The display module 11 may include a display panel 100 for displaying an image. As an example, the display module 11 may include the display panel 100 according to at least one of the embodiments described above.

The processor 12 may include at least one of a central processing unit (CPU), an application processor (AP), a graphic processing unit (GPU), a communication processor (CP), an image signal processor (ISP), and/or a controller.

Data information used for an operation of the processor 12 or the display module 11 may be stored in the memory 13. For example, the memory 13 may store image data signals and/or input control signals.

The processor 12 may control the display module 11 using the information stored in the memory 13. The processor 12 may transmit the image data signals and/or input control signals stored in the memory 13 to the display module 11. For example, when the processor 12 executes an application stored in the memory 13, the image data signals and/or input control signals may be transmitted to the display module 11, and the display module 11 may process the provided signals and output image information through a display screen.

The power module 14 may include a power supply module, such as a power adapter or a battery device, and a power conversion module that converts power supplied by the power supply module to generate power used for an operation of the electronic device 10.

At least one of the components of the electronic device 10 described above may be included in the display device 1 according to some of the above-described embodiments. In addition, some of the individual modules functionally included within one module may be included within the display device 1, while others may be provided separately from the display device 1. For example, the display device 1 includes the display module 11, and the processor 12, the memory 13, and the power module 14 may be provided in the form of other devices within the electronic device 10 other than the display device 1.

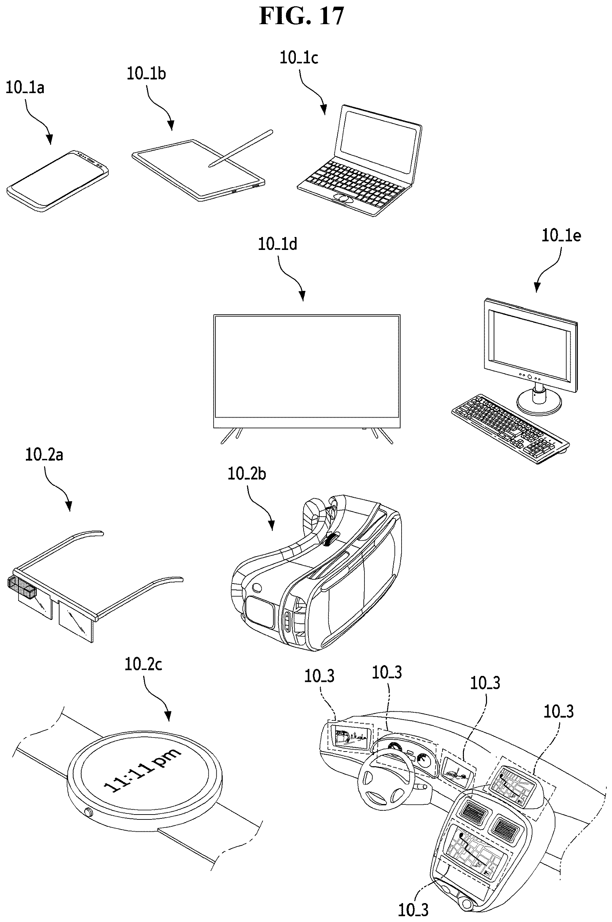

FIG. 17 illustrates schematic diagrams of some electronic devices according to some embodiments.

Referring to FIG. 17, various suitable electronic devices to which the display device 1 according to some embodiments may be applied may include an image display electronic device, such as a smart phone 10_1a, a tablet PC 10_1b, a laptop 10_1c, a TV 10_1d, and a desk monitor 10_1e, as well as a wearable electronic device including a display module, such as a smart glasses 10_2a, a head mounted display 10_2b, a smart watch 10_2c, and the like, and a vehicle electronic device 10_3 including a display module, such as a Center Information Display (CID), a room mirror display, and the like disposed on a vehicle's instrument panel, center fascia, or dashboard.

As described above, the display device 1 and the electronic device 10 according to some embodiments may include the first light emitting area EA1, the second light emitting area EA2, and the third light emitting area EA3, in which the first light emitting element EL1, the second light emitting element EL2, and the third light emitting element EL3 are disposed, respectively. In some embodiments, during the light emitting period of the pixel PX including the first light emitting element EL1, the second light emitting element EL2, and the third light emitting element EL3, a relatively larger voltage may be applied to the third light emitting element EL3. For example, during the light emitting period of the pixel PX that expresses the standard white color (e.g., an achromatic color including gray and white), a relatively larger voltage may be applied to the first electrode AE of the third light emitting element EL3 compared to the voltages applied to the first electrode AE of the first light emitting element EL1 and the first electrode AE of the second light emitting element EL2. In addition, in some embodiments, the second light emitting area EA2 may be disposed closer to the first light emitting area EA1 than the third light emitting area EA3. For example, a spacing between the second light emitting area EA2 and the third light emitting area EA3 may be greater than a spacing between the first light emitting area EA1 and the second light emitting area EA2. According to some embodiments, it may be possible to secure an aperture ratio of the display device 1 and the electronic device 10, while reducing a leakage current of the display device 1 and the electronic device 10.

In some embodiments, the first light emitting element EL1, the second light emitting element EL2, and the third light emitting element EL3 may be a red light emitting element (e.g., a red organic light emitting diode), a green light emitting element (e.g., a green organic light emitting diode), and a blue light emitting element (e.g., a blue organic light emitting diode), respectively. According to some embodiments, by reducing a leakage current that may flow from the third sub-pixel SPX3 to the second sub-pixel SPX2, a driving current Ids of the second sub-pixel SPX2 may be increased, and a temperature sensitivity of the second sub-pixel SPX2 may be lowered. Accordingly, a temperature stability (e.g., a temperature luminance stability and a temperature color stability) of the display device 1 and the electronic device 10 may be improved.

In some embodiments, the display device 1 and the electronic device 10 may further include a separation structure SPT disposed between the second light emitting area EA2 and the third light emitting area EA3 to reduce the leakage current between the sub-pixels SPX. For example, the display device and the electronic device may include a groove formed on the surface of a pixel defining layer PDL and/or a spacer disposed on the pixel defining layer PDL, between the second light emitting area EA2 and the third light emitting area EA3. According to some embodiments, the leakage current of the display device 1 and the electronic device 10 may be more effectively reduced.

In some embodiments, the display device 1 and the electronic device 10 may further include connection holes CT for electrically connecting the light emitting elements EL of each of the sub-pixels SPX to the circuit elements or connection electrodes (e.g., the transistor TFT1 or the second connection electrode PCE2 in FIG. 9) of the backplane layer 120, and the connection holes CT may not be disposed in an area between the first light emitting area EA1 and the second light emitting area EA2, but may be disposed in another portion of the non-light emitting area NEA. According to some embodiments, a design structure of the display device 1 and the electronic device 10 may be improved or optimized, and the connection holes CT of the sub-pixels SPX may be more stably formed.

The foregoing is illustrative of some embodiments of the present invention, and is not to be construed as limiting thereof. Although some embodiments have been described, those skilled in the art will readily appreciate that various modifications are possible in the embodiments without departing from the spirit and scope of the present invention. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present invention as defined in the appended claims.

## Claims

1. A display panel (100) comprising:
a substrate (110);
a pixel defining layer (PDL) on the substrate (110), and defining a plurality of light emitting areas (EA1, EA2.EA3) comprising a first light emitting area (EA1), a second light emitting area (EA2), and a third light emitting area (EA3) that are adjacent to each other; and
a plurality of light emitting elements (EL1, EL2, EL3) on the substrate (110), and comprising a first light emitting element (EL1) in the first light emitting area (EA1), a second light emitting element (EL2) in the second light emitting area (EA2), and a third light emitting element (EL3) in the third light emitting area (EA3),
wherein, during a light emitting period in which the first light emitting element (EL1), the second light emitting element (EL2), and the third light emitting element (EL3) are configured to emit light to express a white color, a first electrode (AE) of the third light emitting element (EL3) is configured to be applied with a third voltage (Va3) greater than a first voltage (Va1) applied to a first electrode (AE) of the first light emitting element (EL1) and a second voltage (Va2) applied to a first electrode (AE) of the second light emitting element (EL2), and
wherein a spacing (SP2, SP4) between the second light emitting area (EA2) and the third light emitting area (EA3) is greater than a spacing (SP1, SP3) between the first light emitting area (EA1) and the second light emitting area (EA2).

2. The display panel (100) of claim 1, wherein a difference between the third voltage (Va3) and the second voltage (Va2) is greater than a difference between the first voltage (Va1) and the second voltage (Va2).

3. The display panel (100) of claim 1 or 2, wherein the first light emitting element (EL1) is a red light emitting element configured to emit red light,
the second light emitting element (EL2) is a green light emitting element configured to emit green light, and
the third light emitting element (EL3) is a blue light emitting element configured to emit blue light.

4. The display panel (100) of at least one of claims 1 to 3, wherein each of the first light emitting element (EL1), the second light emitting element (EL2), and the third light emitting element (EL3) comprises an organic light emitting layer (EML), the organic light emitting layer (EML) being individually located in the first light emitting area (EA1), the second light emitting area (EA2), and the third light emitting area (EA3).

5. The display panel (100) of at least one of claims 1 to 4, wherein, during the light emitting period, the third light emitting element (EL3) is configured to emit light having a lower luminance than those of the first light emitting element (EL1) and the second light emitting element (EL2).

6. The display panel (100) of at least one of claims 1 to 5, wherein, during the light emitting period, a first driving current (Ids1), a second driving current (Ids2), and a third driving current (Ids3) flow through the first light emitting element (EL1), the second light emitting element (EL2), and the third light emitting element (EL3), respectively, and
wherein the third driving current (Ids3) is greater than the first driving current (Ids1) and the second driving current (Ids2).

7. The display panel (100) of at least one of claims 1 to 6, wherein the second light emitting area (EA2) has a shape that extends in a direction toward the first light emitting area (EA1).

8. The display panel (100) of at least one of claims 1 to 7, further comprising a separation structure (SPT) between the second light emitting area (EA2) and the third light emitting area (EA3).

9. The display panel (100) of claim 8, wherein the second light emitting area (EA2) has a shape extending in one direction, and has a long side facing the third light emitting area (EA3), and
wherein the separation structure (SPT) extends in the one direction in which the second light emitting area (EA2) extends, and is parallel to the long side of the second light emitting area (EA2).

10. The display panel (100) of claim 8 or 9, wherein the separation structure (SPT) is located on respective sides of the second light emitting area (EA2).

11. The display panel (100) of at least one of claims 1 to 10, further comprising a backplane layer (120) between a light emitting element layer (130) and the substrate (110), the light emitting element layer (130) comprising the light emitting elements (EL1, EL2, EL3),
wherein the backplane layer (120) comprises transistors (TFT1) electrically connected to the plurality of light emitting elements (EL1, EL2, EL3), and an insulating layer (INS1-5) on the transistors (TFT1).

12. The display panel (100) of claim 11, further comprising connection holes (CT1-3) through which the plurality of light emitting elements (EL1, EL2, EL3) are electrically connected to the transistors (TFT1), the connection holes (CT1-3) penetrating through the insulating layer (INS5),
wherein the connection holes (CT1-3) are not located between the first light emitting area (EA1) and the second light emitting area (EA2) in a non-light emitting area (NEA) around the plurality of light emitting areas (EA1, EA2, EA3), and are located in another portion of the non-light emitting area (NEA).

13. The display panel (100) of claim 12, wherein the plurality of light emitting areas (EA1, EA2, EA3) comprises a plurality of first light emitting areas (EA1) including the first light emitting area (EA1), a plurality of second light emitting areas (EA2) including the second light emitting area (EA2), and a plurality of third light emitting areas (EA3) including the third light emitting area (EA3), and
each of the connection holes (CT1-3) is located between corresponding first and third light emitting areas (EA1, EA3) that are adjacent to each other, or between corresponding second and third light emitting areas (EA2.EA3) that adjacent to each other, among the plurality of light emitting areas (EA1, EA2.EA3).

14. A display device (1) comprising a display module (11) with a display panel (100) according to at least one of claims 1 to 13.

15. An electronic device (10) comprising a display device (1) according to claim 14 and a processor (12) configured to transmit an image data signal to the display module (11).
